(19) Europäisches Patentamt
European Patent Office
Office européen des brevets

(11) EP 2 045 295 B1

(12) # EUROPEAN PATENT SPECIFICATION

(45) Date of publication and mention of the grant of the patent:
**12.12.2012 Bulletin 2012/50**

(21) Application number: **07790927.3**

(22) Date of filing: **18.07.2007**

(51) Int Cl.:
***C08L 79/08*** *(2006.01)* ***B32B 15/088*** *(2006.01)*
***C08G 73/10*** *(2006.01)* ***C08K 5/101*** *(2006.01)*
***C08K 5/3415*** *(2006.01)* ***C09J 179/08*** *(2006.01)*
***H05K 1/03*** *(2006.01)*

(86) International application number:
**PCT/JP2007/064173**

(87) International publication number:
**WO 2008/010514 (24.01.2008 Gazette 2008/04)**

(54) **THERMOCURABLE POLYIMIDE RESIN COMPOSITION**

THERMISCH HÄRTBARE POLYIMIDHARZZUSAMMENSETZUNG

COMPOSITION DE RÉSINE DE POLYIMIDE THERMODURCISSABLE

(84) Designated Contracting States:
**DE**

(30) Priority: **20.07.2006 JP 2006197603**

(43) Date of publication of application:
**08.04.2009 Bulletin 2009/15**

(73) Proprietor: **Mitsubishi Gas Chemical Company, Inc.**
**Tokyo 100-8324 (JP)**

(72) Inventors:
- **BITO, Tsuyoshi**
  **Hiratsuka-shi**
  **Kanagawa 254-0016 (JP)**
- **KIHARA, Shuta**
  **Hiratsuka-shi**
  **Kanagawa 254-0016 (JP)**
- **OISHI, Jitsuo**
  **Hiratsuka-shi**
  **Kanagawa 254-0016 (JP)**

(74) Representative: **Gille Hrabal**
**Patentanwälte**
**Brucknerstrasse 20**
**40593 Düsseldorf (DE)**

(56) References cited:
**EP-A1- 1 514 888** **WO-A2-2006/077964**
**JP-A- 05 059 344** **JP-A- 2001 006 437**
**JP-A- 2005 001 380** **JP-A- 2005 016 629**
**JP-A- 2005 146 170** **JP-A- 2005 171 106**
**JP-A- 2005 306 956**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 045 295 B1

## Description

[Technical Field]

The present invention relates to a thermosetting polyimide resin composition which exhibits satisfactory heat resistance and thermosetting properties and low water absorption properties, a film composed of the subject thermosetting polyimide resin composition, and an adhesive composed of the subject thermosetting polyimide resin composition and a metal-clad laminate using the same. The subject metal-clad laminate is processed into a printed wiring board, a surface heating element, an electromagnetic shielding material, a flat cable.

[Background Technology]

Polyimides have excellent performances in heat resistance, mechanical physical properties, chemical resistance and the like so that they are widely used in an aerospace field, an electronic material field, etc. Most of them are an aromatic polyimide. Most of aromatic polyimides are insoluble in a solvent and non-thermoplastic and had a drawback in processability. Since a polyamic acid which is a precursor is soluble in a solvent, there is adopted a method in which a polyamic acid solution is formed in a desired shape and then imidated. But, the imidation is accompanied with desorption and evaporation of water. The temperature reaches even 300°C or higher at the time of heat imidation and is far in excess of a boiling point of water. In the case of a thick film-shaped molded article, a fault regarding surface properties such as blister, etc. was easily generated. Hence, the selection of a condition at the time of molding, such as temperature setting, involved a difficult aspect. Goods of a polyamic acid produced while omitting this imidation process cannot exhibit durability against heat, etc. inherent to a polyimide. Also, a polyamic acid solution is easily hydrolyzed in the presence of water, and therefore, a method for storing it included a drawback.
As one of methods for solving the foregoing problems, there is a solvent-soluble polyimide. As a matter of course, the solvent-soluble polyimide is able to be formed into a polyimide solution, and therefore, after forming into a desired shape, it can be processed only by volatilizing the organic solvent, whereby goods having good surface properties are easily obtainable. Also, it is excellent in storage stability.
On the other hand, a metal-clad laminate includes one which is manufactured by bonding an insulating base material and a metal layer to each other via an adhesive or an adhesive film. For example, there is proposed a metal-clad laminate of a three-layer structure in which an insulating base material composed of an aromatic polyimide resin film and a metal layer are bonded to each other via an adhesive film (see Patent Document 1).
As the adhesive or adhesive film, those composed mainly of an epoxy based or acrylic resin have hitherto been used. However, since such a resin is inferior in heat resistance, the heat resistance of a product after bonding becomes insufficient, whereby restrictions were generated in subsequent processing condition and use condition.
Accordingly, adhesives and adhesive films which are excellent in heat resistance are required, and a polyimide based resin is widely used as a material which is in response thereto. For example, there are disclosed a method in which a solution of a soluble polyimide resin or a polyamic acid which is a precursor of an insoluble polyimide resin is coated on an insulating base material, and the solvent removal and optionally, an imidation treatment are then carried out, thereby forming an adhesive layer with thermo-compression bonding properties ; a method in which a solution of a polyimide resin or a polyamic acid is coated on a glass sheet, and the solvent removal and optionally, an imidation treatment are then carried out, thereby forming an adhesive film with thermo-compression bonding properties; and a method in which an adherend such as a metal layer, is subjected to thermo-compression bonding on the thus formed adhesive layer or adhesive film (see Patent Documents 2 and 3). The foregoing adhesive layer forming method is roughly classified into a method of using a solution of a polyimide resin and a method of using a solution of a polyamic acid which is a precursor of an insoluble polyimide resin.
In the method of using a polyamic acid solution, in order to form an adhesive layer or an adhesive film after coating a polyamic acid solution on an insulating base material or a glass sheet, an imidation process at a high temperature of 300°C or higher as described previously must be carried out. The heat resistance of a metal-clad laminate which is formed while omitting the imidation process is conspicuously low. In the method of using a solution of a polyimide resin, after coating, it may be sufficient that the solvent is merely volatilized, and an adhesive layer or an adhesive film can be formed at a low temperature of up to about 200°C. Accordingly, the method of using a solution of a polyimide resin is advantageous in manufacturing a metal-clad laminate with high heat resistance. Most of conventional adhesive layers which are composed of a wholly aromatic polyimide resin were formed using a solution of a polyamic acid which is a precursor.
In a metal-clad laminate, there was encountered a problem that when the amount of a residual volatile component of an adhesive layer to be disposed between an insulating base material and a metal layer is high, blanching, blister, foaming, etc. of the adhesive layer is caused during a soldering step reaching a high temperature of 250°C or higher, thereby noticeably hindering adhesive properties between the insulating base material and the metal layer (see Patent

Document 4). Examples of this residual volatile component of the adhesive layer include water and the solvent which have not been removed in imidation and solvent removal steps during the formation of an adhesive layer or an adhesive film; water to be absorbed from the manufacturing environment; water to be absorbed at the time of dipping in an aqueous solution in an etching step; and the like. Of these, water is especially regarded as a problem. In order to solve the foregoing problem, it is desirable to decrease a coefficient of water absorption which is an index of the water content of polyimide.

Also, there is disclosed a heat fusible polyimide resin containing 1,2,4,5-cyclohexanetetracarboxylic acid skeleton in a molecular main chain thereof, which is obtainable from 1,2,4,5-cyclohexanetetracarboxylic dianhydride and a reactive derivative thereof (see Patent Document 6). Example 1 thereof discloses a transparent, yellow polyimide resin film having a glass transition temperature of 304°C, which is obtained by reacting 1,2,4,5-cyclohexanetetracarboxylic dianhydride and a reactive derivative thereof with diaminodiphenylmethane to form an amic acid, which is then coated and subsequently heated for imidation, and this is further heat molded under a pressure. Also, Patent Document 5 discloses that a transparent, less colored polyimide resin film having a glass transition temperature of 300°C or higher is obtainable from a polyimide resin solution which is obtained by using diaminodiphenyl ether.

The foregoing polyimide resin having a 1,2,4,5-cyclohexanetetracarboxylic acid skeleton is advantageous from the standpoint of film fabrication because a high molecular weight is relatively easily achieved, a flexible film is easily obtainable, and the solubility in a solvent is sufficiently large. Also, it is extremely useful because an adhesive layer which is flexible and which has sufficient thickness and durability can be easily formed upon being coated. However, a polyimide resin film described in Patent Document 6 is formed through an imidation step at a high temperature similar to the conventional technology. Also, the polyimide resin films described in Patent Documents 5 and 6 are high in coefficient of water absorption, and a metal-clad laminate using the subject polyimide resin as an adhesive layer was ill at ease in soldering heat resistance.

There is also an example in which a polyimide resin having a 1,2,4,5-cyclohexanetetracarboxylic acid skeleton is applied to a metal-clad laminate (see Patent Document 7). This polyimide resin is solvent-soluble and has an excellent performance as an adhesive layer of a metal-clad laminate. However, since the polyimide resin itself is thermoplastic, a metal-clad laminate in which only this polyimide resin is used as an adhesive layer had a difficult point in processability at a temperature exceeding a flow initiation temperature of this polyimide resin. Also, though its adhesive strength was a necessary and sufficient value, a further enhancement has been desired.

As the adhesive of a metal-clad laminate, there is also an example in which a polyimide resin and a thermosetting compound are made coexistent, thereby imparting thermosetting properties and also enhancing adhesive strength (see Patent Document 8). Even when this method is applied to the polyimide resin described in Patent Document 7, though the coefficient of water absorption as a composition was a low value, it was not sufficient as the adhesive of a metal-clad laminate, the soldering heat resistance involved a difficult point, and a further enhancement has been desired.

Further polyimide resins are described in EP 1 514 888 A1.

[Patent Document 1] JP-A-55-91895
[Patent Document 2] JP-A-5-32950
[Patent Document 3] JP-A-5-59344
[Patent Document 4] JP-A-2001-329246
[Patent Document 5] JP-A-2003-168800
[Patent Document 6] U.S. Patent No. 3,639,343
[Patent Document 7] JP-A-2005-1380
[Patent Document 8] JP-A-2005-171106

[Disclosure of the Invention]

[Problems that the Invention is to Solve]

An object of the present invention is to solve the problems accompanied in the wholly aromatic polyimide resins which have hitherto been used in an adhesive layer and to provide a thermosetting polyimide resin composition which, when used in an adhesive layer, is able to be manufactured by only the solvent removal without requiring an imidation step at a high temperature reaching 300°C or higher and is thermosetting, a cured material of which is excellent in adhesive properties, low in coefficient of water absorption and satisfactory in heat resistance, an adhesive and a film each containing the subject thermosetting polyimide resin composition and a metal-clad laminate including an adhesive layer composed of the subject thermosetting polyimide resin composition.

[Means for Solving the Problems]

The present invention relates to:

(1) A thermosetting polyimide resin composition comprising a polyimide resin containing a repeating unit represented by the following formula (1):

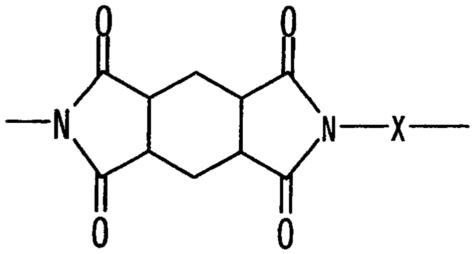

(1)

or a repeating unit represented by the formula (1) and a repeating unit represented by the following formula (2):

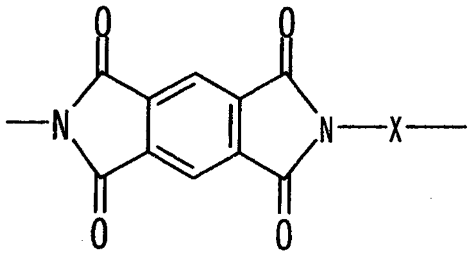

(2)

(in the formulae (1) and (2), X represents a divalent aliphatic group having from 2 to 39 carbon atoms, a divalent alicyclic group having from 3 to 39 carbon atoms, a divalent aromatic group having from 6 to 39 carbon atoms or a divalent group composed of a combination thereof; at least one kind of a bonding group selected from the group consisting of -O-, $-SO_2-$, $-CH_2-$, $-C(CH_3)_2-$, $-OSi(CH_3)_2-$, $-C_2H_4O-$ and -S- may intervene in a main chain of X; and X may have at least one kind of a functional group selected from the group consisting of a carboxyl group, a hydroxyl group and a carbonyl group),
with a proportion of the total sum of at least one kind selected from a group presented by the following formula (3)

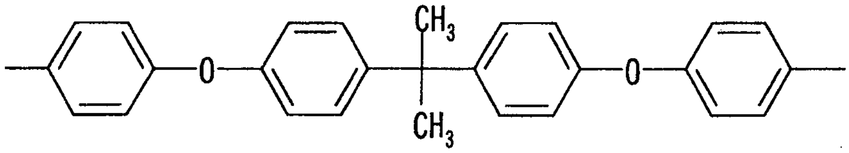

(3)

and a group represented by the following formula (4):

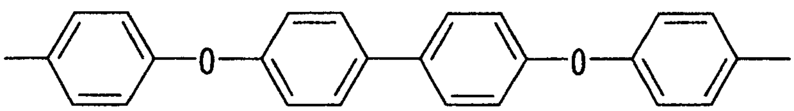

(4)

in the whole of X being 50 % by mole or more, and a compound having two or more polymerizable double bonds in one molecule thereof;
(2) An adhesive containing the thermosetting polyimide resin composition as set forth above in (1);
(3) A thermosetting polyimide resin composition film comprising the thermosetting polyimide resin composition as set forth above in (1);
(4) A method for manufacturing a thermosetting polyimide resin composition film, which includes the steps of casting a solution of the thermosetting polyimide resin composition as set forth above in (1) on a support and evaporating and removing an organic solvent; and

(5) A metal-clad laminate including an insulating base material, a metal layer and an adhesive layer disposed between the subject insulating base material and the metal layer, wherein the subject adhesive layer is formed of the thermosetting polyimide resin composition as set forth above in (1).

[Advantages of the Invention]

The thermosetting polyimide resin composition of the present invention is able to form an adhesive layer upon coating of a solution thereof, can be manufactured by only the solvent removal without requiring a conventional imidation step at a high temperature reaching 300°C or higher and is thermosetting; and a cured material thereof is excellent in adhesive properties, has a low coefficient of water absorption and has satisfactory heat resistance. The metal-clad laminate obtained by using the thermosetting polyimide resin composition of the present invention as an adhesive layer is excellent in adhesion and soldering heat resistance.

[Best Modes for Carrying Out the Invention]

The present invention is hereunder described in detail. The present inventors have found that a polyimide resin containing the foregoing specified repeating unit or units is solvent-soluble and has a low coefficient of water absorption. Furthermore, it has been found that a thermosetting polyimide resin composition comprising the subject polyimide resin and a compound having two or more polymerizable double bonds in one molecule thereof enhances the adhesion to a metal layer and an insulating base material and further that a metal-clad laminate including a metal layer, an insulating base material and an adhesive layer composed of the subject thermosetting polyimide resin composition is excellent in heat resistance.

In the thermosetting polyimide resin composition of the present invention, a polyimide resin composed of a combination of specified repeating units and a compound having two or more polymerizable double bonds in one molecule thereof coexist. The polyimide resin composed of a combination of specified repeating units is a polyimide resin containing a repeating unit represented by the following formula (1):

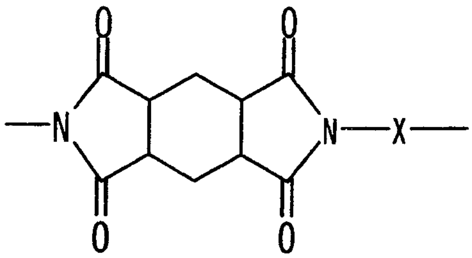

(1)

or a repeating unit represented by the formula (1) and a repeating unit represented by the following formula (2):

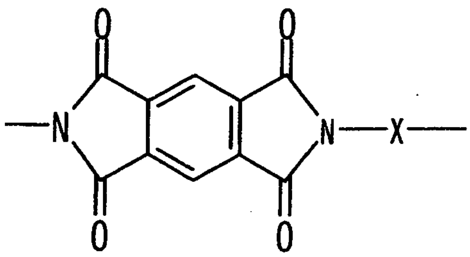

(2)

(in the formulae (1) and (2), X represents a divalent aliphatic group having from 2 to 39 carbon atoms, a divalent alicyclic group having from 3 to 39 carbon atoms, a divalent aromatic group having from 6 to 39 carbon atoms or a divalent group composed of a combination thereof; at least one kind of a bonding group selected from the group consisting of -O-, $-SO_2-$, $-CH_2-$, $-C(CH_3)_2-$, $-OSi(CH_3)_2-$, $-C_2H_4O-$ and -S- may intervene in a main chain of X; and X may have at least one kind of a functional group selected from the group consisting of a carboxyl group, a hydroxyl group and a carbonyl group), with a proportion of the total sum of at least one kind selected from a group presented by the following formula (3):

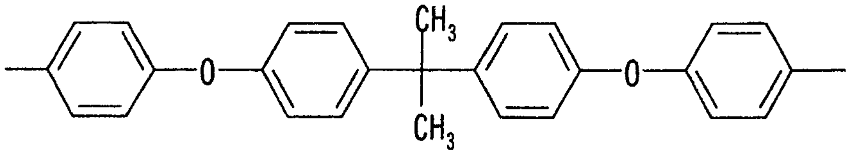

(3)

and a group represented by the following formula (4):

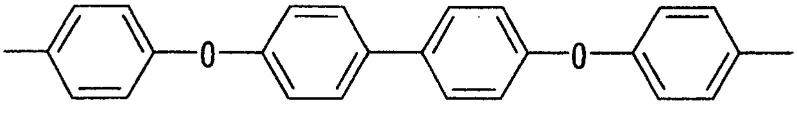

(4)

in the whole of X being 50 % by mole or more. The proportion of the total sum of the groups represented by the formulae (3) and (4), respectively in the whole of X is preferably 70 % by mole or more, and more preferably 80 % by mole or more (each inclusive of 100 % by mole). When the proportion of the foregoing groups is 50 % by mole or more in the whole of X, it is possible to attain low water absorption properties. When the repeating unit represented by the formula (2) is coexistent in the repeating unit represented by the formula (1) capable of bringing solubility in a solvent in the polyimide molecule, the coefficient of water absorption becomes lower.

When the proportion of the total sum of the group represented by the formula (3) and the group represented by the formula (4) in the whole of X is less than 50 % by mole, the coefficient of water absorption is high so that there is a possibility that the soldering heat resistance of a metal-clad laminated sheet containing the subject polyimide resin as an adhesive layer is lowered. A molecular form of the subject polyimide resin may be any of a block copolymer or a random copolymer.

A proportion of the repeating unit represented by the formula (1) is preferably 60 % by mole or more, more preferably 85 % by mole or more, and further preferably 90 % by mole or more (each inclusive of 100 % by mole) of the whole of the repeating units. What the foregoing proportion is 85 % by mole or more is favorable because stability of the solution at ordinary temperature is satisfactory. In the subject polyimide resin, a proportion of the repeating unit represented by the formula (2) to the repeating unit represented by the formula (1) (repeating unit represented by the formula (2) /repeating unit represented by the formula (1)) is preferably from 67 to 0 % by mole, more preferably from 18 to 0 % by mole, and further preferably from 11 to 0 % by mole from the standpoint of stability of the solution at ordinary temperature.

X in the repeating unit represented by the formula (1) and the repeating unit represented by the formula (2) represents a divalent aliphatic group having from 2 to 39 carbon atoms, a divalent alicyclic group having from 3 to 39 carbon atoms, a divalent aromatic group having from 6 to 39 carbon atoms or a divalent group composed of a combination thereof; at least one kind of a bonding group selected from the group consisting of -O-, $-SO_2-$, $-CH_2-$, $-C(CH_3)_2-$, $-OSi(CH_3)_2-$, $-C_2H_4O-$ and -S- may intervene in a main chain of X; and X may have at least one kind of a functional group selected from the group consisting of a carboxyl group, a hydroxyl group and a carbonyl group.

Specific examples thereof include divalent aliphatic groups such as a polyalkylene group, a polyoxyalkylene group, a xylylene group and alkyl substitution products, halogen substitution products, carboxy substitution products and hydroxy substitution products thereof; divalent alicyclic groups derived from cyclohexane, dicyclohexylmethane, dimethylcyclohexane, isophorone, norbornane and alkyl substitution products, halogen substitution products, carboxy substitution products and hydroxy substitution products thereof; and divalent aromatic groups derived from benzene, naphthalene, biphenyl, diphenylmethane, diphenyl ether, diphenyl sulfone, benzophenone and alkyl substitution products, halogen substitution products, carboxy substitution products and hydroxy substitution products thereof, etc. Of these groups, in the present invention, a xylylene group; divalent alicyclic groups derived from isophorone and norbornane; and divalent aromatic groups derived from diphenyl ether, diphenyl sulfone and benzophenone are preferable from the standpoint of solubility in an organic solvent.

The subj ect polyimide resin is obtainable from a reaction of at least one kind of a tetracarboxylic acid component (Y) selected from a tetracarboxylic acid and a reactive derivative thereof and at least one kind of a diamine component (Z) selected from a diamine and a reactive derivative thereof. An end-capping component (W) which is at least one kind of a compound of a dicarboxylic anhydride and a monoamine may be reacted as the case may be. Any of the tetracarboxylic acid component (Y), the diamine component (Z) and the end-capping component (W) may include an isomer thereof.

As the tetracarboxylic acid component (Y), a tetracarboxylic acid, a tetracarboxylic dianhydride, a tetracarboxylic acid ester and the like are preferably exemplified, and tetracarboxylic dianhydrides is more preferable from the standpoint of reactivity. As the tetracarboxylic dianhydride for forming the repeating unit represented by the formula (1) or (2), 1,2,4,5-cyclohexanetetracarboxylic dianhydride (HPMDA) and pyromellitic dianhydride (PMDA) are preferable. The use

amount of HPMDA is preferably 60 % by mole or more, more preferably 85 % by mole or more, and further preferably 90 % by mole or more (each inclusive of 100 % by mole) of the total amount of the whole of the tetracarboxylic acid component from the standpoint of stability of the solution at ordinary temperature.

A proportion of PMDA to HPMDA (PMDA/HPMDA) is preferably from 67 to 0 % by mole, more preferably from 18 to 0 % by mole, and further preferably from 11 to 0 % by mole from the standpoint of stability of the solution at ordinary temperature.

In the present invention, other tetracarboxylic acid component than the foregoing tetracarboxylic acid component (Y) may be used so far as it does not hinder performances of the subject thermosetting polyimide resin composition including solubility in a solvent, heat resistance, adhesive properties, etc. Examples thereof include aromatic tetracarboxylic dianhydrides such as biphenyl-3,4,3',4'-tetracarboxylic dianhydride, biphenyl-2,3,3',4'-tetracarboxylic dianhydride, benzophenone-3,4,3',4'-tetracarboxylic dianhydride, diphenylsulfone-3,4,3',4'-tetracarboxylic dianhydride, 1,4,5,8-naphthalenetetracarboxylic dianhydride, oxydiphthalic dianhydride, 2,2-diphenylpropane-3,4,3',4'-tetracarboxylic dianhydride, 2,2-diphenylpropane-2,3,2',3'-tetracarboxylic dianhydride, 4,4-(m-phenylenedioxy)diphthalic dianhydride, and alicyclic tetracarboxylic dianhydrides such as cyclopentane-1,2,3,4-tetracarboxylic dianhydride, cyclobutane-1,2,3,4-tetracarboxylic dianhydride, etc. One or more kinds thereof can be used simultaneously, and it should not be construed that the present invention is limited thereto.

As the diamine component (Z), a diamine, a diisocyanate, a diaminodisilane and the like are exemplified, and a diamine is preferable from the standpoint of easiness of synthesis. As the diamine for forming the repeating unit represented by the formula (1) and the repeating unit represented by the formula (2), 2,2-bis[4-(4-aminophenoxy)phenyl] propane (BAPP) and 4,4'-bis(4-aminophenoxy)biphenyl (BAPB) are exemplified. The total sum of the use amounts of BAPP and BAPB is preferably 50 % by mole or more, more preferably 70 % by mole or more, and further preferably 80 % by mole or more (each inclusive of 100 % by mole) of the total amount of the whole of the diamine component from the standpoint of low water absorption properties of the polyimide resin.

A diamine component other than BAPP and BAPB is also useful. As such a diamine component, any of an aromatic diamine, an aliphatic diamine, an alicyclic diamine, a diamine having a functional group other than an amino group in a molecule thereof, a reactive derivative of the foregoing diamine and a mixture thereof can be used. The "aromatic diamine" as referred to in the present invention expresses a diamine in which an amino group is bonded directly on an aromatic ring and may contain an aliphatic group, an alicyclic group, an aromatic group or other substituent in a part of a structure thereof. The "aliphatic diamine" as referred to herein expresses a diamine in which an amino group is bonded directly on an aliphatic group and may contain an aliphatic group, an alicyclic group, an aromatic group or other substituent in a part of a structure thereof. The "alicyclic diamine" as referred to herein expresses a diamine in which an amino group is bonded directly on an alicyclic group and may contain an aliphatic group, an alicyclic group, an aromatic group or other substituent in a part of a structure thereof. For example, BAPP is an aromatic diamine because an amino group is bonded directly on an aromatic ring (benzene ring); and m-xylylenediamine (MXDA) is an aliphatic diamine because an amino group is bonded directly on an aliphatic group (methylene group).

In general, when a tetracarboxylic dianhydride is reacted with an aliphatic diamine or an alicyclic diamine, a polyamic acid as an intermediate and an amino group derived from the aliphatic diamine or alicyclic diamine form a firm salt, and therefore, a polyimide having a high molecular weight is hardly obtainable. For that reason, devising, for example, use of a solvent to which the salt has relatively high solubility, such as cresol, or the like is needed. However, when 1,2,4,5-cyclohexanetetracarboxylic dianhydride is used as the tetracarboxylic dianhydride, a polyamic acid and an amino group derived from the aliphatic diamine or alicyclic diamine do no more than form a salt with relatively weak bonding, and therefore, an imidation reaction relatively easily proceeds, and a high molecular weight can be easily achieved.

Examples of the aliphatic diamine include ethylenediamine, hexamethylenediamine, polyethylene glycol bis(3-aminopropyl)ether, polypropylene glycol bis(3-aminopropyl)ether, 1,3-bis(aminomethyl)cyclohexane, 1,4-bis(aminomethyl)cyclohexane, p-xylylenediamine, m-xylylenediamine (MXDA), siloxanediamines, etc.

Examples of the alicyclic diamine include 4,4'-diaminodicyclohexylmethane, isophoronediamine, norbornanediamine, reactive derivatives thereof, etc.

Examples of the aromatic diamine include 1,4-phenylenediamine, 1,3-phenylenediamine, 2,4-toluenediamine, 4,4'-diaminodiphenyl ether, 3,4'-diaminodiphenyl ether, 4,4'-diaminodiphenylmethane, 1,4-bis(4-aminophenoxy)benzene, 1,3-bis(4-aminophenoxy)benzene, 1,3-bis(3-aminophenoxy)benzene, $\alpha,\alpha'$-bis(4-aminophenyl)-1,4-diisopropylbenzene, $\alpha,\alpha'$-bis(3-aminophenyl)-1,4-diisopropylbenzene, 4,4'-diaminodiphenylsulfone, bis[4-(4-aminophenoxy)phenyl]sulfone, bis[4-(3-aminophenoxy)phenyl]sulfone, 2,6-diaminonaphthalene, 1,5-diaminonaphthalene, reactive derivatives thereof

Examples of the foregoing diamine having a functional group other than an amino group include 3,3'-dicarboxy-4,4'-diaminodiphenylmethane, 3,5-diaminobenzoic acid, 3,3'-dihydroxy-4,4'-diaminobiphenyl, 2,4-diaminophenol, 4,4'-diaminobenzophenone, 3,3'-diaminobenzophenone, reactive derivatives thereof.

When MXDA, 1,3-phenylenediamine, 4,4'-diaminodiphenylmethane, 1,3-bis(3-aminophenoxy)benzene, bis [4-(4-aminophenoxy)phenyl]sulfone, 3,3'-dicarboxy-4,4'-diaminodiphenylmethane, 3,5-diaminobenzoic acid, 3,3'-dihydroxy-4,4'-dimainobiphenyl or 4,4'-diaminobenzophenone is selected among the foregoing amines as the diamine component other than BAPP and BAPB, an adhesive resin composition using the subject polyimide resin is more excellent in a balance among various properties including low water absorption properties, adhesive properties, heat resistance and the like as an adhesive layer of the metal-clad laminated sheet, and therefore, such is preferable.

In general, a molecular end of the polyimide is an amino group, a carboxyl group or a carboxylic anhydride group. By reacting a compound having a dicarboxylic anhydride group or an amino group as the end-capping component (W) on such a molecular end, it is possible to decrease the functional group on the molecular end, or to intentionally introduce a functional group such as an amino group, a carboxyl group or a substituent other than this into the molecular end. In order to lower the coefficient of water absorption of the thermosetting polyimide resin composition, it is effective to introduce a substituent with low polarity into the molecular end of the subject polyimide. From the standpoint of soldering heat resistance of the obtained metal-clad laminated sheet, the coefficient of water absorption of the adhesive resin composition after curing, which is measured by a method as described later, is preferably not more than 2.5 %, more preferably not more than 2.2 %, and further preferably not more than 1.8 %. A minimum value of the coefficient of water absorption which can be industrially achieved is usually about 1 %.

As the end-capping component (W) of the polyimide, a dicarboxylic anhydride, a monoamine are applicable. Examples of the dicarboxylic anhydride include phthalic anhydride, naphthalenedicarboxylic anhydride, biphenyldicarboxylic anhydride, 1,2,3,6-tetrahydrophthalic anhydride, 1,2-cyclohexanedicarboxylic anhydride, 5-norbornene-2,3-dicarboxylic anhydride (nadic anhydride, NAn), methyl-5-norbornene-2,3-dicarboxylic anhydride, citraconic anhydride (CAn), maleic anhydride (MAn), 3-ethynylphthalic acid, 4-ethynylphthalic acid, 4-phenylethynylphthalic acid.

Examples of the monoamine include aniline, aminonaphthalene, aminobiphenyl, 3-ethynylaniline, 4-ethynylaniline. It should not be construed that the end-capping agent is limited thereto. These can be used singly or in combination of two or more kinds thereof.

The subject polyimide resin can be manufactured by reacting the tetracarboxylic acid component (Y) in an amount of preferably from 0.66 to 1.5 moles, more preferably from 0.9 to 1.1 moles, and further preferably from 0.97 to 1.03 moles per mole of the diamine component (Z). Also, by regulating the molar ratio in the foregoing manner and further adding an appropriate amount of the end-capping component or not adding it, it is possible to make the polyimide resin have desired molecular weight and logarithmic viscosity. By regulating the logarithmic viscosity $\eta$ of the subject polyimide resin, which is measured at 30°C using a 0.5 g/dL solution in N-methyl-2-pyrrolidone, in the range of preferably from 0.3 to 2 dL/g, and more preferably from 0.3 to 1.5 dL/g, it is possible to enhance an adhesive force of the thermosetting polyimide resin composition.

In general, the subject polyimide resin can be manufactured as an organic solvent solution containing this and an organic solvent.

Though the organic solvent is not particularly limited, for example, N-methyl-2-pyrrolidone, N,N-dimethylacetamide, N, N-diethylacetamide, N,N-dimethylformamide, N,N-diethylformamide, N-methylcaprolactam, hexamethylphosphoramide, tetramethylene sulfone, dimethyl sulfoxide, m-cresol, phenol, p-chlorophenol, 2-chloro-4-hydroxytoluene, diglyme, triglyme, tetraglyme, dioxane, $\gamma$-butyrolactone, dioxolan, cyclohexanone, cyclopentanone, dichloromethane, chloroform, 1,2-dichloroethane, 1,1,2-trichloroethane, dibromomethane, tribromomethane, 1,2-dibromoethane, 1,1,2-tribromoethane and the like are useful; and two or more kinds of these organic solvents may be used in combination. However, taking into consideration the performance of a polyimide varnish composed of the polyimide resin composition and the solvent, it is preferable to use N-methyl-2-pyrrolidone (NMP), N,N-dimethylacetamide (DMAC) or $\gamma$-butyrolactone (GBL) singly or in combination.

The organic solvent is used in an amount such that the concentration of the polyimide resin composition in the obtained organic solvent solution is preferably from 1 to 50 % by weight, and more preferably from 5 to 40 % by weight. Also, in the case of the manufacture by solution polymerization, a poor solvent, for example, hexane, heptane, benzene, toluene, xylene, chlorobenzene, o-dichlorobenzene, etc. can be used in combination with the foregoing solvent to an extent that a polymer is not deposited.

The subject polyimide resin can be manufactured by (1) a solution polymerization method, (2) a method in which a polyamic acid solution is prepared, subjected to fabrication and imidated, (3) a method in which a salt such as a half ester salt of a tetracarboxylic dianhydride, etc. or an imide oligomer is obtained and subjected to solid phase polymerization, (4) a method in which a tetracarboxylic dianhydride and a diisocyanate are reacted, or other methods which have hitherto been publicly known. These methods may be employed in combination. Also, the manufacture may be carried out in the presence of a catalyst which has hitherto been publicly known, for example, acids such as aromatic carboxylic acids, anhydrides, amines such as aromatic amines, aliphatic amines, tertiary amines, etc. , and the like.

Of these methods, the following solution polymerization method (a) or (b) is preferable from the standpoint of the matter that the organic solvent solution of the polyimide resin is directly obtainable.

Method (a):

(a1-1) A mixture containing the diamine component (Z) and an organic solvent and optionally, a catalyst is stirred at from 10 to 600 rpm to form a uniform solution, which is then kept at a temperature of from 30 to 90°C, and the tetracarboxylic acid component (Y) and optionally, a catalyst are added. Alternatively,

(a1-2) A mixture containing the tetracarboxylic acid component (Y) and an organic solvent and optionally, a catalyst is stirred at from 10 to 600 rpm to form a uniform solution, which is then kept at a temperature of from 30 to 90°C, and the diamine component (Z) and optionally, a catalyst are added.

(a2) After the method (a1-1) or (a1-2), the temperature is raised to 160 to 230°C, and preferably 180 to 205°C over from 0.1 to 6 hours. This temperature is influenced by a boiling point of the organic solvent to be used. The temperature is kept substantially constant for from 0.5 to 24 hours, preferably from 1 to 12 hours, and more preferably from 1 to 6 hours while collecting the components to be removed outside the reaction system.

(a3) If desired, after cooling to 10 to 205°C, the end-capping component (W) and optionally, an organic solvent and/or a catalyst are added, and the temperature is raised to 150 to 205°C, and preferably 160 to 200°C. The temperature is kept substantially constant for from 0.5 to 24 hours, and preferably from 1 to 6 hours while collecting the components to be removed outside the reaction system. Thereafter, if desired, an organic solvent is further added, and the mixture is cooled to an appropriate temperature.

Method (b):

(b1-1) A mixture containing the diamine component (Z), an organic solvent and optionally, a catalyst is stirred at from 10 to 600 rpm to form a uniform solution, which is then kept at a temperature of from 30 to 90°C, and the tetracarboxylic acid component (Y), optionally, the end-capping component (W) and optionally, a catalyst are added. Alternatively,

(b1-2) A mixture containing the tetracarboxylic acid component (Y), optionally, the end-capping component (W), an organic solvent and optionally, a catalyst is stirred at from 10 to 600 rpm to form a uniform solution, which is then kept at a temperature of from 30 to 90°C, and the diamine component (Z) and optionally, a catalyst are added.

(b2) After the method (b1-1) or (b1-2), the temperature is raised to 160 to 230°C, and preferably 180 to 205°C over from 0.1 to 6 hours. This temperature is influenced by a boiling point of the organic solvent to be used. The temperature is kept substantially constant for from 0.5 to 24 hours, and preferably from 2 to 12 hours while collecting the components to be removed outside the reaction system. Thereafter, if desired, an organic solvent is further added, and the mixture is cooled to an appropriate temperature.

As the catalyst to be used in the solution polymerization for manufacturing the polyimide resin, a tertiary amine compound is preferable; specific examples thereof include trimethylamine, triethylamine (TEA), tripropylamine, tributylamine, triethanolamine, N,N-dimethylethanolamine, N,N-diethylethanolamine, triethylenediamine, N-methylpyrrolidine, N-ethylpyrrolidine, N-methylpiperidine, N-ethylpiperidine, imidazole, pyridine, quinoline, isoquinoline ; and the reaction can be carried out in the presence of at least one kind of a catalyst selected from these materials. In the case of using the catalyst, from the standpoint of carrying out the reaction in a low amount of the catalyst for a period of time as short as possible, the use amount of the catalyst is preferably from 0.1 to 100 % by mole, and more preferably from 1 to 10 % by mole relative to the tetracarboxylic acid component (Y).

The compound having two or more polymerizable double bonds in one molecule thereof, which constitutes the thermosetting polyimide resin composition, is a maleimide compound and/or an epoxy (meth) acrylate compound which are preferable from the standpoint of heat resistance of the cured material of the thermosetting polyimide resin composition.

The subject maleimide compound is composed of a compound represented by either one of the following formula (5):

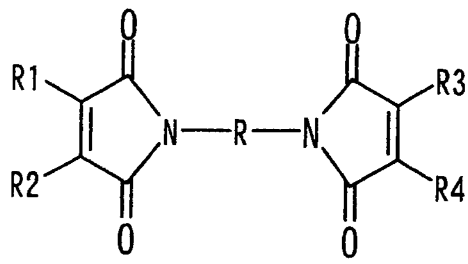

(5)

(in the formula, R represents a divalent organic group; and R1 to R4 each represents a hydrogen atom or a hydrocarbon group),
and the following formula (6):

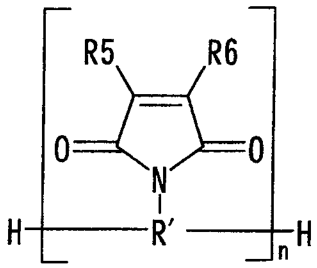

(6)

(in the formula, n represents an integer of from 2 to 10; R' represents at least one kind of a trivalent organic group; and R5 and R6 each represents a hydrogen atom or a hydrocarbon group).

Here, examples of the hydrocarbon group represented by each of R1 to R6 in the formulae (5) and (6) include an alkyl group such as a methyl group, an ethyl group, etc. Examples of the divalent organic group represented by R in the formula (5) include divalent aliphatic groups such as a polyalkylene group, a polyoxyalkylene group, a xylylene group and alkyl substitution products, halogen substitution products, carboxy substitution products and hydroxy substitution products thereof, divalent alicyclic groups derived from cyclohexane, dicyclohexylmethane, dimethylcyclohexane, isophorone, norbornane and alkyl substitution products, halogen substitution products, carboxy substitution products and hydroxy substitution products thereof, divalent aromatic groups derived from benzene, naphthalene, biphenyl, diphenylmethane, diphenyl ether, diphenyl sulfone, benzophenone and alkyl substitution products, halogen substitution products, carboxy substitution products and hydroxy substitution products thereof, and divalent organic groups formed from two or more of these divalent organic groups directly or via at least one kind of a bonding group selected from the group consisting of -O-, $-SO_2-$, $-CH_2-$, $-C(CH_3)_2-$, $-OSi(CH_3)_2-$, $-C_2H_4O-$ and -S-.

Also, examples of the trivalent organic group represented by R' in the formula (6) include trivalent aromatic groups derived from benzene, naphthalene and alkyl substitution products, halogen substitution products, carboxy substitution products and hydroxy substitution products thereof. R's in the respective repeating units of the formula (6) may be the same or different. The compound represented by the formula (6) further includes one in which R' is bonded to R' which other repeating unit has via at least one kind of a bonding group selected from the group consisting of -O-, $-SO_2-$, $-CH_2-$, $-C\ (CH_3)_2-$, $-OSi\ (CH_3)_2-$, $-C_2H_4O-$ and -S-; and can also include one in which R' is bonded to R' which other compound represented by the formula (6) has via the foregoing bonding group.

Examples of the maleimide compound to be used in the present invention include N,N'-(4,4'-diphenylmethane) bismaleimide, N,N'-(4,4'-diphenyloxy)bismaleimide, N,N'-(4,4'-diphenylsulfone)bismaleimide, N,N'-p-phenylenebismaleimide, N,N'-m-phenylenebismaleimide, N,N'-2,4-tolylenebismaleimide, N,N'-2,6-tolylenebismaleimide, N,N'-ethylenebismaleimide, N,N'-hexamethylenebismaleimide, N,N'-{4,4'-[2,2'-bis(4",4"'-phenoxyphenyl)isopropylidene]} bismaleimide, N,N'-{4,4'-[2,2'-bis(4",4"'-phenoxyphenyl)hexafluoroisopro pylidene]}bismaleimide, N,N'-[4,4'-bis(3,5-dimethylphenyl)methane]bismaleimide, N,N'-[4,4'-bis(3,5-diethylphenyl)methane]bismaleimide, N,N'-[4,4'-(3-methyl-5-ethylphenyl)methane]bismaleimide, N,N'-[4,4'-bis(3,5-diisopropylphenyl)methane]bismaleimide, N,N'-(4,4'-dicyclohexylmethane)bismaleimide, N,N'-p-xylylenebismaleimide, N,N'-m-xylylenebismaleimide, N,N'-m-xylylenebiscitracoimide, N,N'-(1,3-dimethylenecyclohexane)bismaleimide, N,N'-(1,4-dimethylenecyclohexane)bismaleimide, polyphenylmethanemaleimide and the like. It should not be construed that the present invention is limited thereto. Of these, N,N'-(4,4'-diphenylmethane)bismaleimide, N,N'-[4,4'-bis(3-methyl-5-ethylphenyl)methane]bismaleimide and polyphenylmethanemaleimide are preferable from the standpoint of heat resistance of the thermosetting polyimide resin composition.

The epoxy (meth)acrylate compound is composed of a compound represented by either one of the following formula (7):

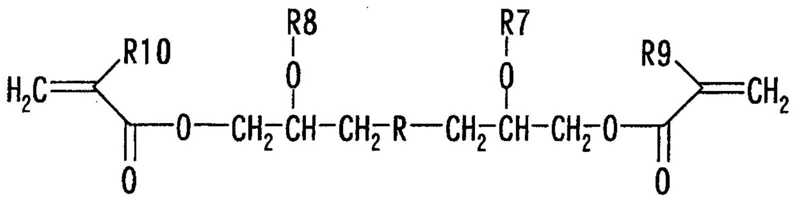

(7)

(in the formula, R represents a divalent organic group; R7 and R8 each represents a hydrogen atom or a monovalent organic group and may have a reactive group such as a polymerizable double bond, and R9 and R10 each represents a hydrogen atom or a methyl group),
and the following formula (8):

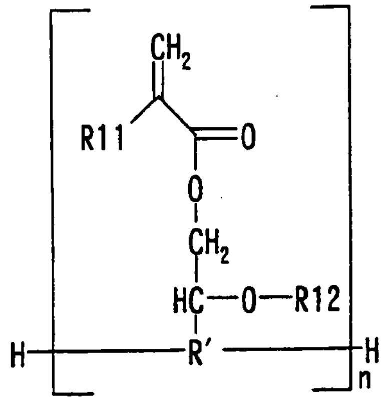

(8)

(in the formula, n represents an integer of from 2 to 10; R' represents at least one kind of a trivalent organic group; R11 represents a hydrogen atom or a methyl group; and R12 represents a monovalent organic group).

Here, examples of the monovalent organic group represented by each of R7, R8 and R12 in the formulae (7) and (8) include monovalent aliphatic groups such as an alkyl group, an alkenyl group, an alkylene group, a polyalkylene group, a polyoxyalkylene group and alkyl substitution products, halogen substitution products, carboxy substitution products and hydroxy substitution products thereof; monovalent alicyclic groups derived from cyclohexane, dicyclohexylmethane, dimethylcyclohexane, isophorone, norbornane and alkyl substitution products, halogen substitution products, carboxy substitution products and hydroxy substitution products thereof ; monovalent aromatic groups derived from benzene, naphthalene, biphenyl, diphenylmethane, diphenyl ether, diphenyl sulfone, benzophenone and alkyl substitution products, halogen substitution products, carboxy substitution products and hydroxy substitution products thereof ; and monovalent organic groups formed from two or more of these monovalent organic groups directly or via at least one kind of a bonding group selected from the group consisting of -O-, $-SO_2-$, $-CH_2-$, $-C(CH_3)_2-$, $-OSi(CH_3)_2-$, $-C_2H_4O-$ and -S-. The divalent organic group represented by R in the formula (7) is the same as in the foregoing formula (5); and the trivalent organic group represented by R' in the formula (8) is the same as in the foregoing formula (6). The compound represented by the formula (8) further includes one in which R' is bonded to R' which other repeating unit has via at least one kind of a bonding group selected from the group consisting of -O-, $-SO_2-$, $-CH_2-$, $-C(CH_3)_2-$, $-OSi(CH_3)_2-$, $-C_2H_4O-$ and -S-; and can also include one in which R' is bonded to R' which other compound represented by the formula (8) has via the foregoing bonding group.

Examples of the epoxy (meth) acrylate compound to be used in the present invention include a bisphenol A type epoxy methacrylate (a trade name: NEOPOL 8110, manufactured by Japan U-Pica Company Ltd.; and a trade name: NEOPOL 8130, manufactured by Japan U-Pica Company Ltd.); a bisphenol A type epoxy acrylate; a bisphenol F type epoxy (meth)acrylate; a phenol novolak type epoxy methacrylate (a trade name: NEOPOL 8131, manufactured by Japan U-Pica Company Ltd.); a phenol novolak type epoxy acrylate; a cresol novolak type epoxy (meth)acrylate . From the viewpoint of heat resistance, it is preferable that the subject epoxy (meth)acrylate compound has one or more benzene rings in one molecule thereof.

The subject epoxy (meth)acrylate compound is synthesized by a method which has hitherto been publicly known. Representatively, there is exemplified a method of reacting an epoxy compound containing at least two epoxy groups in one molecule thereof with an unsaturated monobasic acid. However, it should not be construed that the present invention is limited thereto. Examples of the unsaturated monobasic acid include acrylic acid and methacrylic acid.

The thermosetting polyimide resin composition according to the present invention may contain an epoxy group-containing compound, a carbon-carbon triple bond-containing compound, a carbon-nitrogen triple bond-containing compound, a compound having one polymerizable double bond in one molecule thereof, such as monoacrylates, a polymerization initiator such as peroxides, an inorganic filler such as silica, or other additives so far as performances as an adhesive layer of the metal-clad laminate are not hindered.

A proportion of the compound having two or more polymerizable double bonds in one molecule thereof in the thermosetting polyimide resin composition is preferably from 0.1 to 60 % by weight. When the subject proportion is 0.1 % by weight or more, an effect for enhancing the adhesive strength is sufficiently exhibited. Also, when the proportion is not more than 60 % by weight, a crosslinking density of the subject thermosetting polyimide resin composition is not excessively large but appropriate, and satisfactory mechanical physical properties are obtainable; and therefore, such is preferable as an adhesive layer of the metal-clad laminate. From the foregoing viewpoints, the proportion of the compound having two or more polymerizable double bonds in one molecule thereof in the thermosetting polyimide resin composition is more preferably from 1 to 50 % by weight, and further preferably from 10 to 40 % by weight. Similarly, from the standpoint of enhancing mechanical physical properties and adhesive strength of the obtained metal-clad laminate, a proportion of the subject polyimide resin in the thermosetting polyimide resin composition is preferably from 40 to 99.9 % by weight, more preferably from 50 to 99 % by weight, and further preferably from 60 to 90 % by weight.

The subject thermosetting polyimide resin composition contains the subject polyimide resin and the compound having two or more polymerizable double bonds in one molecule thereof, which is a maleimide compound and/or an epoxy (meth) acrylate compound. The unsaturated bond of such a compound is able to cause an addition reaction to which the subject unsaturated bond contributes between the molecules constituting the thermosetting polyimide resin composition which is an adhesive layer of the metal-clad laminate at the time of molding, thereby enhancing the reliability on adhesion and soldering heat resistance of the metal-clad laminate. As to the reason why in the metal-clad laminate in which the subject thermosetting polyimide resin composition forms an adhesive layer, after the subject thermosetting polyimide resin composition advances an addition reaction, the adhesion and soldering heat resistance are enhanced, it is estimated to be a cause that a network structure is formed within the molecule due to the addition reaction to which the unsaturated bond existing in the subject thermosetting polyimide resin composition contributes, and a cured material is formed, whereby the strength of the adhesive layer itself is enhanced.

The unsaturated bond of the subject polymerizable double bond-containing compound and the reactive group which the subject polyimide resin has in a molecular end thereof as the case may be commence an addition reaction in the range of from 240 to 280°C. Accordingly, at the time of heat pressing in forming the metal-clad laminate or at the time of subsequently allowing it to stand, when a heat history of keeping the temperature in the range of from 240 to 350°C including the range of from 240 to 280°C for one minute or more, preferably 5 minutes or more, more preferably 10 minutes or more, and especially preferably 30 minutes or more elapses, the addition reaction of the thermosetting polyimide resin composition thoroughly proceeds to form a cured material, whereby the adhesion and soldering heat resistance in the case of forming a metal-clad laminate are enhanced. When the temperature is lower than 240°C, there is a tendency that it takes a lot of time to achieve the addition reaction.

A surfactant such as fluorine substituted or polysiloxane based surfactants, etc. may be added in the solution of the thermosetting polyimide resin composition. According to this, it becomes easy to obtain an adhesive layer and a thermosetting polyimide resin composition film, each of which has satisfactory surface smoothness.

The present invention also provides an adhesive containing the foregoing polyimide resin composition.

Also, the polyimide resin composition film of the present invention is composed of the foregoing polyimide resin composition. The subject thermosetting polyimide resin composition film can be manufactured by coating (casting) the organic solvent solution of the subject thermosetting polyimide resin composition on a smooth support preferably provided with release properties, such as glass sheets, metal sheets, and preferably heating at from 50 to 220°C to evaporate and remove the organic solvent. It is preferable that the solvent is evaporated and removed preferably at a temperature of not higher than 120°C to form a self-supporting film; the subject film is then peeled away from the support; ends of the subject film are fixed; and the film is dried at from 50 to 220°C to manufacture a thermosetting polyimide resin composition film. The pressure of the drying atmosphere may be any of reduced pressure, atmospheric pressure or elevated pressure.

In the case of use in an adhesive layer of the metal-clad laminate, a thickness of the thermosetting polyimide resin composition film is preferably from 1 to 100 $\mu$m, and more preferably from 2 to 50 $\mu$m.

The metal-clad laminate of the present invention includes an insulating base material, a metal layer and an adhesive layer containing the adhesive resin composition to be disposed therebetween.

The metal-clad laminate can be manufactured by a method in which an organic solvent solution of the thermosetting polyimide resin composition is coated on one or both of an insulating base material and a metal layer, the organic solvent is evaporated and removed preferably at from 50 to 220°C to form an adhesive layer, and the insulating base material and the metal layer are then superimposed via the adhesive layer, followed by thermo-compression bonding; a method in which the foregoing thermosetting polyimide resin composition film is disposed between an insulating base material and a metal layer, followed by thermo-compression bonding; or other method. Also, the metal-clad laminate in which an insulating base material and a metal layer are firmly bonded to each other can also be manufactured by a method

in which a metal thin membrane is formed directly on one surface of a thermosetting polyimide resin composition film by a method such as sputtering, vapor deposition, electroless plating, and an insulating base material is placed on the other surface, followed by thermo-compression bonding; or a method in which an adhesive layer is formed on the surface of an insulating base material, and a metal thin membrane is formed on the surface of the subject adhesive layer by a method such as sputtering, vapor deposition, electroless plating, etc. From the standpoints of easiness of coating and adhesive force, a thickness of the adhesive layer is preferably from 1 to 100 μm, and more preferably from 2 to 50 μm.

The metal layer may also be formed of a metal foil obtainable by a method such as electrolysis, rolling. As described previously, the metal layer may also be formed directly on the surface of the polyimide resin film or the surface of the adhesive layer formed on the insulating base material. Though the thickness of the metal layer is not particularly limited, it is preferably in the range of from 1 to 100 μm from the standpoints of handling properties and strength. The material of the metal layer is preferably copper. Also, one surface (adhesive surface) or both surfaces of the metal foil may be subjected to a surface treatment such that the surface roughness Rz is from 0.1 to 12 μm. In the case of a metal layer which is generally called a low profile, such as a copper foil, from the standpoints of fine pitch and adhesive force, Rz is preferably from 0.1 to 4 μm, more preferably from 0.1 to 2 μm, further preferably from 0.4 to 2 μm, and still further preferably from 1.0 to 2 μm. In the metal foil which has not been subjected to a surface treatment for bonding, in many occasions, its surface is generally treated with a preservative, and therefore, it is preferable to use the metal foil after wiping the surface by a cloth having acetone or other organic solvent permeated thereinto or other method.

The insulating base material of the present invention is not particularly limited so far as it is able to electrically insulate the metal layer. Also, the insulating base material includes a flexible type and a rigid type, and all of these types are useful. Though the thickness of the insulating base material varies with the foregoing type, it is preferably from 3 to 2,000 μm. Examples of the insulating base material of a flexible type include films made of a polyimide resin (exclusive of the polyimide resin used in the foregoing adhesive layer), a polybenzimidazole, a polybenzoxazole, a polyamide (including aramid), a polyetherimide, a polyamide-imide, a polyester (including a liquid crystalline polyester), a polysulfone, a polyethersulfone, a polyetherketone, a polyetheretherketone, and of these, a polyimide resin film is preferable from the standpoints of flexibility, insulating properties and heat resistance. Specific examples thereof include trade names, "KAPTON EN", "KAPTON V" and "KAPTON H" (manufactured by Du Pont-Toray Co. , Ltd.); trade names, "APICAL NPI" and "APICAL AH" (manufactured by Kaneka Corporation); a trade name, "UPILEX-S" (manufactured by Ube Industries, Ltd.); and the like. Though its thickness is not particularly limited, it is preferably from 3 to 150 μm, and more preferably from 7.5 to 75 μm.

Examples of the insulating base material of a rigid type include those obtained by forming an insulating coating on an insulating material sheet or a metal sheet such as a glass sheet, a ceramic sheet, a plastic sheet, and moldings obtained by impregnating and kneading a reinforcing material such as a glass fiber cloth, a plastic fiber cloth, a glass short fiber, with a thermoplastic or thermosetting resin of every sort, such as a liquid crystal polymer, a phenol resin, an epoxy resin, etc. Though its thickness is not particularly limited, it is preferably from 30 to 2,000 μm.

As the method of thermo-compression bonding, in general, a method by a multi-daylight (vacuum) press, a continuous pressing method using a pressure roll, and the like can be properly adopted.

The temperature of the thermo-compression bonding is preferably from 200 to 400°C, and more preferably from 250 to 350°C. The pressure of the thermo-compression bonding is preferably from 0.01 to 20 MPa, and more preferably from 0.1 to 10 MPa. Also, for the purpose of removing the solvent and air bubbles, it is preferable to achieve the thermo-compression bonding under a reduced pressure atmosphere. At the time of the thermo-compression bonding, the addition reaction to which the unsaturated bond of the subject unsaturated bond-containing compound in the thermosetting polyimide resin composition and the reactive group which the subject polyimide resin has in a molecular end thereof as the case may be contribute proceeds at the same time. The thermo-compression bonding time is not particularly limited. However, when the thermo-compression bonding time is 0.5 hours or more, even by shortening a standing time for the purpose of enhancing the adhesion as a metal-clad laminate as described below, satisfactory adhesion can be exhibited without carrying out it as the case may be.

After the thermo-compression bonding, when the metal-clad laminate is allowed to stand under a reduced pressure or nitrogen atmosphere at preferably from 100 to 400°C, and more preferably from 150 to 350°C for preferably from 0.5 to 72 hours, and more preferably from 0.5 to 12 hours, the adhesion as the metal-clad laminate increases, and therefore, such is preferable as the metal-clad laminate.

When the metal layer of the metal-clad laminate of the present invention has a peel strength, as measured according to the peel strength measurement method of a copper foil by peeling at 90° in conformity with JIS C6471 as described later, of 0.5 N/mm or more, it can be put into practical use. The peel strength is preferably 0.8 N/mm or more, and more preferably 1.0 N/mm or more.

[Examples]

The present invention is specifically described below with reference to the following Examples. However, it

should be construed that the present invention is not limited thereto at all. Measurement methods of physical properties are hereunder shown.

(1) IR spectrum:

An IR spectrum was measured using JIR-WINSPEC50, manufactured by JEOL Ltd.

(2) Logarithmic viscosity η:

A solution of 0.5 g/dL of a polyimide in N-methyl-2-pyrrolidone was prepared. A liquid level drop time of this solution between marked lines was measured in a constant-temperature water bath at 30°C by a Cannon-Fenske viscometer, and a logarithmic viscosity η was determined according to the following expression.

$$\eta\ (dL/g) = \ln\left((\text{drop time of solution})/(\text{drop time of N-methyl-2-pyrrolidone})\right)/0.5$$

As to the logarithmic viscosity, its value closely resembles to an intrinsic viscosity and can be determined simply and easily.

(3) Coefficient of water absorption of film:

A coefficient of water absorption of a polyimide was determined according to the method of IPC-TM-650 2.6.2.1.
After drying a film of 50.8 mm × 50.8 mm at 120°C for one hour, its weight ($W_0$) was measured. This film was dipped in distilled water at 23°C for 24 hours, and after wiping off water on the surface, its weight ($W_1$) was rapidly measured.

$$\text{Coefficient of water absorption (\%)} = [(W_1 - W_0) \div W_0] \times 100$$

(4) Peel strength of metal layer:

A peel strength of a metal layer was determined according to the peel strength measurement method of a copper foil by peeling at 90° in conformity with JIS C6471 (method A using a rotating drum type support fitting for peel strength measurement).

(5) Soldering heat resistance:

The following test was carried out while referring to JIS C6471.
A specimen of 10 mm × 50 mm was cut out from a metal-clad laminate and allowed to stand in a constant-temperature chamber at a humidity of 50 % and 23°C for 24 hours. Subsequently, the specimen was floated on a soldering bath for 20 seconds. Separate specimens were used at a temperature of 260°C and 280°C. The case where appearance abnormality such as blister, peeling, was not caused was designated as "A"; and the case where appearance abnormality was caused was designated as "C".

<u>Synthesis Example 1</u>

In a 300-mL five-necked glass-made round bottom flask which was provided with a Dean-Stark equipped with a stainless steel-made semicircular stirring blade, a nitrogen introducing tube and a cooling tube, a thermometer and a glass-made end cap, 27.43 g (0.06682 moles) of 2,2-bis[4-(4-aminophenoxy)phenyl]propane (BAPP, manufactured by Wakayama Seika Kogyo Co., Ltd.), 50.89 g of γ-butyrolactone (GBL, manufactured by Mitsubishi Chemical Corporation) and 0.34 g of triethylamine (TEA, manufactured by Kanto Chemical Co., Inc.) as a catalyst were stirred under a nitrogen atmosphere at 100 rpm, thereby obtaining a solution.
14.98 g (0.06682 moles) of 1,2,4,5-cyclohexanetetracarboxylic dianhydride (HPMDA, manufactured by Mitsubishi Gas Chemical Company, Inc.) and 12.72 g of N,N-dimethylacetamide (DMAC, manufactured by Mitsubishi Gas Chemical Company, Inc.) were collectively added thereto, respectively, and the mixture was then heated by a mantle

heater, thereby raising the temperature within the reaction system to 180°C over about 20 minutes. The temperature within the reaction system was kept at 180°C for 6 hours while collecting a component to be distilled off.

After adding 96.39 g of N,N-dimethylacetamide (DMAC), the mixture was stirred at around 130°C for about 30 minutes, thereby forming a uniform solution, which was then cooled to 100°C over about 10 minutes. There was thus obtained a polyimide resin solution having a solids content of 20 % by weight.

The obtained polyimide resin solution was coated on a smooth glass sheet on which an extremely small amount of a release agent had been sprayed by a coater and then heated on a hot plate at 100°C for one hour, thereby forming a self-supporting film. The film which had been peeled away from the glass sheet was fixed in several places by clips onto a stainless steel-made frame and then allowed to stand in a vacuum dryer at 200°C for 5 hours, thereby removing the solvent substantially completely (less than 1 % by weight). There was thus obtained a polyimide resin film. As a result of measuring the IR spectrum of this polyimide resin film, characteristic absorption of an imide ring was observed at ν (C=O) of 1,774 and 1,706 ($cm^{-1}$). This polyimide resin had a logarithmic viscosity of 1.00 dL/g.

Synthesis Example 2

In the same five-necked glass-made round bottom flask as that used in Synthesis Example 1, 26.48 g (0.07187 moles) of 4,4'-bis(4-aminophenoxy)biphenyl (BAPB, manufactured by Wakayama Seika Kogyo Co. , Ltd.), 51.11 g of GBL and 0.36 g of TEA as a catalyst were stirred under a nitrogen atmosphere at 100 rpm, thereby obtaining a solution.

16.11 g (0.07187 moles) of HPMDA and 12.78 g of DMAC were collectively added thereto, respectively, and the mixture was then heated by a mantle heater, thereby raising the temperature within the reaction system to 180°C over about 20 minutes. The temperature within the reaction system was kept at 180°C for 3.5 hours while collecting a component to be distilled off.

After adding 96.11 g of DMAC, the mixture was stirred at a temperature in the vicinity of 130°C for about 30 minutes, thereby forming a uniform solution, which was then cooled to 100°C over about 10 minutes. There was thus obtained a polyimide resin solution having a solids content of 20 % by weight.

A polyimide resin film was obtained in the same manner as in Synthesis Example 1, except for using the obtained polyimide resin solution. As a result of measuring an IR spectrum of this polyimide resin film, characteristic absorption of an imide ring was observed at ν (C=O) of 1,779 and 1,704 ($cm^{-1}$). This polyimide resin had a logarithmic viscosity η of 1.28 dL/g.

Synthesis Example 3

In the same five-necked glass-made round bottom flask as that used in Synthesis Example 1, 25.87 g (0.06302 moles) of BAPP, 0.95 g (0.00700 moles) of m-xylylenediamine (MXDA, manufactured by Mitsubishi Gas Chemical Company, Inc.), 50.00 g of N-methyl-2-pyrrolidone (NMP, manufactured by Mitsubishi Chemical Corporation) and 0.35 g of TEA as a catalyst were stirred under a nitrogen atmosphere at 100 rpm, thereby obtaining a solution.

15.70 g (0.07002 moles) of HPMDA and 13.79 g of NMP were collectively added thereto, respectively, and the mixture was then heated by a mantle heater, thereby raising the temperature within the reaction system to 200°C over about 20 minutes. The temperature within the reaction system was kept at 200°C for 5 hours while collecting a component to be distilled off.

After adding 96.21 g of DMAC, the mixture was stirred at a temperature in the vicinity of 130°C for about 30 minutes, thereby forming a uniform solution, which was then cooled to 100°C over about 10 minutes. There was thus obtained a polyimide resin solution having a solids content of 20 % by weight.

A polyimide resin film was obtained in the same manner as in Synthesis Example 1, except for using the obtained polyimide resin solution. As a result of measuring the IR spectrum of this polyimide resin film, characteristic absorption of an imide ring was observed at ν (C=O) of 1,772 and 1,704 ($cm^{-1}$). This polyimide resin had a logarithmic viscosity η of 0.63 dL/g.

Synthesis Example 4

In the same five-necked glass-made round bottom flask as that used in Synthesis Example 1, 27.46 g (0.06689 moles) of BAPP, 50.00 g of NMP and 0.34 g of TEA as a catalyst were stirred under a nitrogen atmosphere at 100 rpm, thereby obtaining a solution.

13.49 g (0.06020 moles) of HPMDA, 1.46 g (0.00669 moles) of pyromellitic dianhydride (PMDA, manufactured by Mitsubishi Gas Chemical Company, Inc.) and 13.62 g of NMP were collectively added thereto, respectively, and the mixture was then heated by a mantle heater, thereby raising the temperature within the reaction system to 200°C over about 20 minutes. The temperature within the reaction system was kept at 200°C for 5 hours while collecting a component to be distilled off.

After adding 96.38 g of DMAC, the mixture was stirred at a temperature in the vicinity of 130°C for about 30 minutes, thereby forming a uniform solution, which was then cooled to 100°C over about 10 minutes. There was thus obtained a polyimide resin solution having a solids content of 20 % by weight.

A polyimide resin film was obtained in the same manner as in Synthesis Example 1, except for using the obtained polyimide resin solution. As a result of measuring an IR spectrum of this polyimide resin film, characteristic absorption of an imide ring was observed at ν (C=O) of 1,776 and 1,706 ($cm^{-1}$). This polyimide resin had a logarithmic viscosity η of 1.09 dL/g.

Synthesis Example 5

In the same five-necked glass-made round bottom flask as that used in Synthesis Example 1, 27.43 g (0.06682 moles) of BAPP, 50.00 g of NMP and 0.30 g of TEA as a catalyst were stirred under a nitrogen atmosphere at 100 rpm, thereby obtaining a solution.

13.48 g (0.06014 moles) of HPMDA and 7.00 g of NMP were collectively added thereto, respectively, and the mixture was then heated by a mantle heater, thereby raising the temperature within the reaction system to 200°C over about 20 minutes. The temperature within the reaction system was kept at 200°C for 5 hours while collecting a component to be distilled off.

The reaction mixture was cooled to 160°C over about 5 minutes, 1.50 g (0.01336 moles) of citraconic anhydride (CAn, manufactured by Tokyo Chemical Industry Co., Ltd.) and 6.61 g of NMP were collectively added, respectively, and the mixture was then heated by a mantle heater, thereby raising the temperature within the reaction system to 175°C over about 10 minutes. The temperature within the reaction system was kept at 175°C for 2.5 hours while collecting a component to be distilled off.

After adding 96.39 g of DMAC, the mixture was stirred at a temperature in the vicinity of 130°C for about 30 minutes, thereby forming a uniform solution, which was then cooled to 100°C over about 10 minutes. There was thus obtained a polyimide A solution having a solids content of 20 % by weight.

A film was obtained in the same manner as in Synthesis Example 1, except for using the obtained polyimide A solution. As a result of measuring an IR spectrum of this film, characteristic absorption of an imide ring was observed at ν (C=O) of 1,776 and 1, 704 ($cm^{-1}$). This polyimide A had a logarithmic viscosity η of 0.52 dL/g.

Synthesis Example 6

In the same five-necked glass-made round bottom flask as that used in Synthesis Example 1, 20.62 g (0.10299 moles) of 4,4'-diaminodiphenyl ether (ODA, manufactured by Wakayama Seika Kogyo Co., Ltd.), 52.45 g of GBL and 0.52 g of TEA were stirred under a nitrogen atmosphere at 100 rpm, thereby obtaining a solution.

23.09 g (0.10299 moles) of HPMDA and 13.11 g of DMAC were collectively added thereto, respectively, and the mixture was then heated by a mantle heater, thereby raising the temperature within the reaction system to 180°C over about 20 minutes. The temperature within the reaction system was kept at 180°C for 3 hours while collecting a component to be distilled off.

After adding 94.43 g of DMAC, the mixture was stirred at a temperature in the vicinity of 130°C for about 30 minutes, thereby forming a uniform solution, which was then cooled to 100°C over about 10 minutes. There was thus obtained a polyimide resin solution having a solids content of 20 % by weight.

A polyimide resin film was obtained in the same manner as in Synthesis Example 1, except for using the obtained polyimide resin solution. As a result of measuring an IR spectrum of this polyimide resin film, characteristic absorption of an imide ring was observed at ν (C=O) of 1,772 and 1,700 ($cm^{-1}$). This polyimide had a logarithmic viscosity η of 0.90 dL/g and a coefficient of water absorption of 5.7 %.

Synthesis Example 7

In the same five-necked glass-made round bottom flask as that used in Synthesis Example 1, 22.50 g (0.1004 moles) of HPMDA, 31.42 g of NMP, 20.36 g of DMAC and 0.51 g of TEA as a catalyst were stirred under a nitrogen atmosphere at 100 rpm, thereby obtaining a solution.

In a 200-mL beaker, 21.12 g (0.1004 moles) of 4,4'-diaminodicyclohexylmethane (DCHM, manufactured by New Japan Chemical Co. , Ltd.) which has been heated at about 80°C was dissolved in 40.00 g of NMP, and the solution was transferred into a 200-mL dropping funnel together with 10.00 g of NMP. The glass-made end cap of the five-necked glass-made round bottom flask was taken away, the subject 200-mL dropping funnel was installed, and the mixture was dropped over about 2 hours. After completion of dropping, the internal temperature was regulated to 90°C over 10 minutes, thereby keeping at 90°C for 5 hours. Thereafter, the mixture was then heated by a mantle heater, thereby raising the temperature within the reaction system to 180°C over about 20 minutes. The temperature within the reaction

system was kept at 180°C for 2 hours while collecting a component to be distilled off.

After adding 58.23 g of DMAC, the mixture was stirred at around 130°C for about 30 minutes, thereby forming a uniform solution, which was then cooled to 100°C over about 10 minutes. There was thus obtained a polyimide resin solution having a solids content of 20 % by weight.

A polyimide resin film was obtained in the same manner as in Synthesis Example 1, except for using the obtained polyimide resin solution. As a result of measuring an IR spectrum of this polyimide resin film, characteristic absorption of an imide ring was observed at ν (C=O) of 1,768 and 1,689 ($cm^{-1}$). This polyimide had a logarithmic viscosity of 0.49 dL/g and a coefficient of water absorption of 6.5 %.

<u>Synthesis Example 8</u>

In the same five-necked glass-made round bottom flask as that used in Synthesis Example 1, 22.29 g (0.05429 moles) of BAPP, 3.17 g (0.02327 moles) of MXDA and 50.00 g of NMP were stirred under a nitrogen atmosphere at 100 rpm, thereby obtaining a solution.

15.65 g (0.06980 moles) of HPMDA, 1.69 g (0.00776 moles) of PMDA and 14.19 g of NMP were collectively added thereto, respectively, and the mixture was then heated by a mantle heater, thereby raising the temperature within the reaction system to 200°C over about 20 minutes. The temperature within the reaction system was kept at 200°C for 6 hours while collecting a component to be distilled off.

After adding 95.81 g of DMAC, the mixture was stirred at a temperature in the vicinity of 130°C for about 30 minutes, thereby forming a uniform solution, which was then cooled to 100°C over about 10 minutes. There was thus obtained a polyimide resin solution having a solids content of 20 % by weight.

A polyimide resin film was obtained in the same manner as in Synthesis Example 1, except for using the obtained polyimide resin solution. As a result of measuring the IR spectrum of this polyimide resin film, characteristic absorption of an imide ring was observed at ν (C=O) of 1,773 and 1,705 ($cm^{-1}$). This polyimide resin had a logarithmic viscosity of 0.92 dL/g and a coefficient of water absorption of 1.7 %.

<u>Synthesis Example 9</u>

In the same five-necked glass-made round bottom flask as that used in Synthesis Example 1, 10.91 g (0.02658 moles) of BAPP, 12.42 g (0.06202 moles) of ODA, 50.00 g of NMP and 0.45 g of TEA as a catalyst were stirred under a nitrogen atmosphere at 100 rpm, thereby obtaining a solution.

19.86 g (0.08860 moles) of HPMDA and 14.79 g of NMP were collectively added thereto, respectively, and the mixture was then heated by a mantle heater, thereby raising the temperature within the reaction system to 180°C over about 20 minutes. The temperature within the reaction system was kept at 180°C for 4 hours while collecting a component to be distilled off.

After adding 95.21 g of DMAC, the mixture was stirred at a temperature in the vicinity of 130°C for about 30 minutes, thereby forming a uniform solution, which was then cooled to 100°C over about 10 minutes. There was thus obtained a polyimide resin solution having a solids content of 20 % by weight.

A polyimide resin film was obtained in the same manner as in Synthesis Example 1, except for using the obtained polyimide resin solution. As a result of measuring the IR spectrum of this polyimide resin film, characteristic absorption of an imide ring was observed at ν (C=O) of 1,774 and 1,702 ($cm^{-1}$). This polyimide resin had a logarithmic viscosity of 0.96 dL/g and a coefficient of water absorption of 4.2 %.

Table 1

| | Tetracarboxylic acid component | | | | End-capping component | | Diamine component | | | | Logarithmic viscosity η |
|---|---|---|---|---|---|---|---|---|---|---|---|
| | Name | % by mole | Name | % by mole | Name | % by mole | Name | % by mole | Name | % by mole | |
| Synthesis Example 1 | HPMDA | 100 | | | | | BAPP | 100 | | | 1.00 |
| Synthesis Example 2 | HPMDA | 100 | | | | | BAPB | 100 | | | 1.28 |

(continued)

| | Tetracarboxylic acid component | | | | End-capping component | | Diamine component | | | | Logarithmic viscosity η |
|---|---|---|---|---|---|---|---|---|---|---|---|
| | Name | % by mole | Name | % by mole | Name | % by mole | Name | % by mole | Name | % by mole | |
| Synthesis Example 3 | HPMDA | 100 | | | | | BAPP | 90 | MXDA | 10 | 0.63 |
| Synthesis Example 4 | HPMDA | 90 | PMDA | 10 | | | BAPP | 100 | | | 1.09 |
| Synthesis Example 5 | HPMDA | 90 | | | CAn | 20 | BAPP | 90 | | | 0.52 |
| Synthesis Example 6 | HPMDA | 100 | | | | | ODA | 100 | | | 0.90 |
| Synthesis Example 7 | HPMDA | 100 | | | | | DCHM | 100 | | | 0.49 |
| Synthesis Example 8 | HPMDA | 90 | PMDA | 10 | | | BAPP | 70 | MXDA | 30 | 0.92 |
| Synthesis Example 9 | HPMDA | 100 | | | | | BAPP | 30 | ODA | 70 | 0.96 |

Example 1

In a 50-mL beaker, 3.50 g of the polyimide resin solution obtained in Synthesis Example 1, 0.30 g of a maleimide compound (polyphenylmethanemaleimide; a trade name: BMI-2300, manufactured by Daiwa Fine Chemicals Co. , Ltd.) and 6.20 g of DMAC were stirred by a glass rod to form a uniform solution. There was thus obtained a thermosetting polyimide resin composition solution.

The obtained thermosetting polyimide resin composition solution was coated on a smooth glass sheet on which an extremely small amount of a release agent had been sprayed by a coater and then heated on a hot plate at 100°C for one hour, thereby forming a self-supporting film. The film which had been peeled away from the glass sheet was fixed in several places by clips onto a stainless steel-made frame and then allowed to stand stepwise in a vacuum dryer at 80°C for one hour, at 200°C for one hour and at 280°C for 5 hours, respectively, thereby removing the solvent substantially completely (less than 1 % by weight) and curing the film. There was thus obtained a cured material film of the thermosetting polyimide resin composition (thickness: 25 μm). This cured material film of the thermosetting polyimide resin composition had a coefficient of water absorption of 1.4 %.

A 25 μm-thick polyimide resin film (a trade name: KAPTON 100EN, manufactured by Du Pont-Toray Co., Ltd.) was used as an insulating base material; and the above-obtained thermoplastic polyimide resin composition solution was coated on one surface thereof, heated on a hot plate at 80°C for 0.5 hours and then dried in a vacuum dryer at 80°C for 5 hours, thereby forming an adhesive layer having a thickness of 4 μm on the insulating base material. An 18 μm-thick electrolytic copper foil having been subjected to a surface roughing treatment for bonding and having Rz of 3.8 μm (a product name: 3EC-VLP, manufactured by Mitsui Mining & Smelting Co., Ltd.) was used as a metal layer, and the electrolytic copper foil was superimposed on the adhesive layer formed on the insulating base material via the roughed surface. This was sandwiched by stainless steel mirror finished sheets, put into hot plates of a heat press at a temperature of 330°C and kept at a contact pressure (0 MPa) for 3 minutes, followed by thermo-compression bonding under a condition at 330°C and 5 MPa for 30 minutes. Subsequently, the resultant was put between hot plates of a pressing machine at ordinary temperature and cooled under a condition at 5 MPa for 2 minutes, thereby obtaining a metal-clad laminate. The peel strength of the metal layer of the obtained metal-clad laminate was 1.80 N/mm, and the

solder heat resistance was rated as "A".

Example 2

In a 50-mL beaker, 4. 50 g of the polyimide resin solution obtained in Synthesis Example 1, 0.10 g of a maleimide compound (N,N'-(4,4'-diphenylmethane)bismaleimide; a trade name: BMI-H, manufactured by K.I Chemical Industry Co., Ltd.) and 5.40 g of DMAC were stirred by a glass rod to form a uniform solution. There was thus obtained a thermosetting polyimide resin composition solution.

A cured material film of the thermosetting polyimide resin composition (thickness: 25 μm) was obtained in the same manner as in Example 1, except for using the obtained thermosetting polyimide resin composition solution. This cured material film of the thermosetting polyimide resin composition had a coefficient of water absorption of 1.5 %.

A metal-clad laminate was obtained in the same manner as in Example 1, except for using the obtained thermosetting polyimide resin composition solution. The peel strength of the metal layer of the obtained metal-clad laminate was 1.59 N/mm, and the solder heat resistance was rated as "A".

Example 3

In a 50-mL beaker, 4.95 g of the polyimide resin solution obtained in Synthesis Example 2, 0.10 g of BMI-2300 as a maleimide compound and 5.04 g of DMAC were stirred by a glass rod to form a uniform solution. There was thus obtained a thermosetting polyimide resin composition solution.

A cured material film of the thermosetting polyimide resin composition (thickness: 25 μm) was obtained in the same manner as in Example 1, except for using the obtained thermosetting polyimide resin composition solution. This cured material film of the thermosetting polyimide resin composition had a coefficient of water absorption of 2.1 %.

A metal-clad laminate was obtained in the same manner as in Example 1, except for using the obtained thermosetting polyimide resin composition solution. The peel strength of the metal layer of the obtained metal-clad laminate was 1.76 N/mm, and the solder heat resistance was rated as "A".

Example 4

In a 50-mL beaker, 4.00 g of the polyimide resin solution obtained in Synthesis Example 3, 0.20 g of a maleimide compound (N,N'-[4,4'-bis(3-methyl-5-ethylpheny)methane]bismaleimide ; a trade name: BMI-5100, manufactured by Daiwa Fine Chemicals Co., Ltd.) and 5.80 g of DMAC were stirred by a glass rod to form a uniform solution. There was thus obtained a thermosetting polyimide resin composition solution.

A cured material film of the thermosetting polyimide resin composition (thickness: 25 μm) was obtained in the same manner as in Example 1, except for using the obtained thermosetting polyimide resin composition solution. This cured material film of the thermosetting polyimide resin composition had a coefficient of water absorption of 1.8 %.

A metal-clad laminate was obtained in the same manner as in Example 1, except for using the obtained thermosetting polyimide resin composition solution. The peel strength of the metal layer of the obtained metal-clad laminate was 1.62 N/mm, and the solder heat resistance was rated as "A".

Example 5

In a 50-mL beaker, 4.50 g of the polyimide resin solution obtained in Synthesis Example 4, 0.10 g of a bisphenol A type epoxy methacrylate compound (a trade name: NEOPOL 8110, manufactured by Japan U-Pica Company Ltd.) and 5.40 g of DMAC were stirred by a glass rod to form a uniform solution. There was thus obtained a thermosetting polyimide resin composition solution.

A cured material film of the thermosetting polyimide resin composition (thickness: 25 μm) was obtained in the same manner as in Example 1, except for using the obtained thermosetting polyimide resin composition solution. This cured material film of the thermosetting polyimide resin composition had a coefficient of water absorption of 1.3 %.

A metal-clad laminate was obtained in the same manner as in Example 1, except for using the obtained thermosetting polyimide resin composition solution. The peel strength of the metal layer of the obtained metal-clad laminate was 1.63 N/mm, and the solder heat resistance was rated as "A".

Example 6

In a 50-mL beaker, 4.95 g of the polyimide resin solution obtained in Synthesis Example 5, 0.10 g of NEOPOL 8110 as an epoxy methacrylate compound and 5.04 g of DMAC were stirred by a glass rod to form a uniform solution. There was thus obtained a thermosetting polyimide resin composition solution.

A cured material film of the thermosetting polyimide resin composition (thickness: 25 μm) was obtained in the same manner as in Example 1, except for using the obtained thermosetting polyimide resin composition solution. This cured material film of the thermosetting polyimide resin composition had a coefficient of water absorption of 1.4 %.

A 25 μm-thick polyimide resin film (a trade name: KAPTON 100EN, manufactured by Du Pont-Toray Co., Ltd.) was used as an insulating base material; and the above-obtained thermoplastic polyimide resin composition solution was coated on one surface thereof, heated on a hot plate at 80°C for 0.5 hours and then dried in a vacuum dryer at 80°C for 5 hours, thereby forming an adhesive layer having a thickness of 4 μm on the insulating base material. A 9 μm-thick electrolytic copper foil having been subjected to a surface roughing treatment for bonding and having Rz of 1.5 μm (a product name: F2-WS, manufactured by Furukawa Circuit Foil Co., Ltd.) was used as a metal layer, and the electrolytic copper foil was superimposed on the adhesive layer formed on the insulating base material via the roughed surface. This was sandwiched by stainless steel mirror finished sheets, put into hot plates of a heat press at a temperature of 330°C and kept at a contact pressure (0 MPa) for 3 minutes, followed by thermo-compression bonding under a condition at 330°C and 5 MPa for 30 minutes. Subsequently, the resultant was put between hot plates of a pressing machine at ordinary temperature and cooled under a condition at 5 MPa for 2 minutes, thereby obtaining a metal-clad laminate. The peel strength of the metal layer of the obtained metal-clad laminate was 1.45 N/mm, and the solder heat resistance was rated as "A".

<u>Example 7</u>

In a 50-mL beaker, 4.00 g of the polyimide resin solution obtained in Synthesis Example 2, 0.20 g of a bisphenol A type epoxy methacrylate compound (a trade name: NEOPOL 8130, manufactured by Japan U-Pica Company Ltd.) and 5.80 g of DMAC were stirred by a glass rod to form a uniform solution. There was thus obtained a thermosetting polyimide resin composition solution.

A cured material film of the thermosetting polyimide resin composition (thickness: 25 μm) was obtained in the same manner as in Example 1, except for using the obtained thermosetting polyimide resin composition solution. This cured material film of the thermosetting polyimide resin composition had a coefficient of water absorption of 1.3 %.

A metal-clad laminate was obtained in the same manner as in Example 1, except for using the obtained thermosetting polyimide resin composition solution. The peel strength of the metal layer of the obtained metal-clad laminate was 1.55 N/mm, and the solder heat resistance was rated as "A".

<u>Example 8</u>

In a 50-mL beaker, 3.50 g of the polyimide resin solution obtained in Synthesis Example 1, 0.30 g of NEOPOL 8110 as an epoxy methacrylate compound and 6.20 g of DMAC were stirred by a glass rod to form a uniform solution. There was thus obtained a thermosetting polyimide resin composition solution.

A cured material film of the thermosetting polyimide resin composition (thickness: 25 μm) was obtained in the same manner as in Example 1, except for using the obtained thermosetting polyimide resin composition solution. This cured material film of the thermosetting polyimide resin composition had a coefficient of water absorption of 1.3 %.

A metal-clad laminate was obtained in the same manner as in Example 1, except for using the obtained thermosetting polyimide resin composition solution. The peel strength of the metal layer of the obtained metal-clad laminate was 1.74 N/mm, and the solder heat resistance was rated as "A".

<u>Example 9</u>

In a 50-mL beaker, 4. 00 g of the polyimide resin solution obtained in Synthesis Example 8, 0.20 g of a phenol novolak type epoxy methacrylate compound (a trade name: NEOPOL 8131, manufactured by Japan U-Pica Company Ltd.) and 5.80 g of DMAC were stirred by a glass rod to form a uniform solution. There was thus obtained a thermosetting polyimide resin composition solution.

A cured material film of the thermosetting polyimide resin composition (thickness: 25 μm) was obtained in the same manner as in Example 1, except for using the obtained thermosetting polyimide resin composition solution. This cured material film of the thermosetting polyimide resin composition had a coefficient of water absorption of 1.5 %.

A metal-clad laminate was obtained in the same manner as in Example 1, except for using the obtained thermosetting polyimide resin composition solution. The peel strength of the metal layer of the obtained metal-clad laminate was 1.78 N/mm, and the solder heat resistance was rated as "A".

<u>Comparative Example 1</u>

In a 50-mL beaker, 5.00 g of the polyimide resin solution obtained in Synthesis Example 6 and 5. 00 g of DMAC

were stirred by a glass rod to form a uniform solution. A film of the polyimide resin (thickness: 25 μm) and a metal-clad laminate were obtained in the same manner as in Example 1, except for using the obtained solution. This polyimide resin is not thermosetting. The obtained film had a high coefficient of water absorption as 5.7 %; and the metal layer of the obtained metal-clad laminate could be easily peeled away and was extremely low in peel strength.

Comparative Example 2

In a 50-mL beaker, 4. 00 g of the polyimide resin solution obtained in Synthesis Example 6, 0.20 g of BMI-H as a maleimide compound and 5.80 g of DMAC were stirred by a glass rod to form a uniform solution. There was thus obtained a thermosetting polyimide resin composition solution.

A cured material film of the thermosetting polyimide resin composition (thickness: 25 μm) was obtained in the same manner as in Example 1, except for using the obtained thermosetting polyimide resin composition solution. This cured material film of the thermosetting polyimide resin composition had a coefficient of water absorption of 5.0 %.

A metal-clad laminate was obtained in the same manner as in Example 1, except for using the obtained thermosetting polyimide resin composition solution. The peel strength of the metal layer of the obtained metal-clad laminate was 0.89 N/mm, and the solder heat resistance was rated as "C".

Comparative Example 3

In a 50-mL beaker, 5.00 g of the polyimide resin solution obtained in Synthesis Example 7 and 5.00 g of DMAC were stirred by a glass rod to form a uniform solution. A film of the polyimide resin (thickness: 25 μm) and a metal-clad laminate were obtained in the same manner as in Example 1, except for using the obtained solution. This polyimide resin is not thermosetting. The obtained film had a high coefficient of water absorption as 6.5 %. The peel strength of the metal layer of the obtained metal-clad laminate was 0.65 N/mm, and the solder heat resistance was rated as "C".

Comparative Example 4

In a 50-mL beaker, 5.00 g of the polyimide resin solution obtained in Synthesis Example 1 and 5.00 g of DMAC were stirred by a glass rod to form a uniform solution. A film of the polyimide resin (thickness: 25 μm) and a metal-clad laminate were obtained in the same manner as in Example 1, except for using the obtained solution. This polyimide resin is not thermosetting. The obtained film had a coefficient of water absorption of 1.6 %. The peel strength of the metal layer of the obtained metal-clad laminate was 0.62 N/mm, and the solder heat resistance was rated as "A".

Comparative Example 5

In a 50-mL beaker, 4.50 g of the polyimide resin solution obtained in Synthesis Example 9, 0.10 g of NEOPOL 8110 as an epoxy methacrylate compound and 5.40 g of DMAC were stirred by a glass rod to form a uniform solution. There was thus obtained a thermosetting polyimide resin composition solution.

A cured material film of the thermosetting polyimide resin composition (thickness: 25 μm) was obtained in the same manner as in Example 1, except for using the obtained thermosetting polyimide resin composition solution. This cured material film of the thermosetting polyimide resin composition had a coefficient of water absorption of 3.8 %.

A metal-clad laminate was obtained in the same manner as in Example 1, except for using the obtained thermosetting polyimide resin composition solution. The peel strength of the metal layer of the obtained metal-clad laminate was 0.35 N/mm, and the solder heat resistance was rated as "C".

Table 2

| No. | Polyimide resin Synthesis Example | Proportion (% by weight) | Maleimide compound | Proportion (% by weight) | Epoxy (meth) acrylate compound | Proportion (% by weight) | Peel strength (N/mm) | Coefficient of water absorption of film (%) | Soldering heat resistance |
|---|---|---|---|---|---|---|---|---|---|
| Example 1 | 1 | 70 | BMI-2300 | 30 | - | - | 1.80 | 1.4 | A |
| Example 2 | 1 | 90 | BMI-H | 10 | - | - | 1.59 | 1.5 | A |
| Example 3 | 2 | 99 | BMI-2300 | 1 | - | - | 1.76 | 2.1 | A |
| Example 4 | 3 | 80 | BMI-5100 | 20 | - | - | 1.62 | 1.8 | A |
| Example 5 | 4 | 90 | - | - | 8110 | 10 | 1.63 | 1.3 | A |
| Example 6 | 5 | 99 | - | - | 8110 | 1 | 1.45 | 1.4 | A |
| Example 7 | 2 | 80 | - | - | 8130 | 20 | 1.55 | 1.3 | A |
| Example 8 | 1 | 70 | - | - | 8110 | 30 | 1.74 | 1.3 | A |
| Example 9 | 8 | 80 | | | 8131 | 20 | 1.78 | 1.5 | A |
| Comparative Example 1 | 6 | 100 | - | - | - | - | - | (5.7) * | - |
| Comparative Example 2 | 6 | 80 | BMI-H | 20 | - | - | 0.89 | 5.0 | C |
| Comparative Example 3 | 7 | 100 | - | - | - | - | 0.65 | (6.5)* | C |
| Comparative Example 4 | 1 | 100 | - | - | - | - | 0.62 | (1.6)* | A |
| Comparative Example 5 | 9 | 90 | - | - | 8110 | 10 | 0.35 | 3.8 | C |

*As to the coefficient of water absorption of film of Comparative Examples 1,3 and 4, the values provided with a parenthesis are not a value of the cured material but a value of only the polyimide resin.

[Industrial Applicability]

The polyimide resin composition of the present invention includes a thermosetting polyimide resin composition which is thermosetting, a cured material of which is excellent in adhesive properties, low in coefficient of water absorption and satisfactory in heat resistance, and therefore, it is favorably used for a film, an adhesive and a metal-clad laminate using the subject adhesive as an adhesive layer; and the subject metal-clad laminate is processed into a printed wiring board, a surface heating element, an electromagnetic shielding material, a flat cable.

## Claims

**1.** A thermosetting polyimide resin composition comprising
a polyimide resin containing a repeating unit represented by the following formula (1):

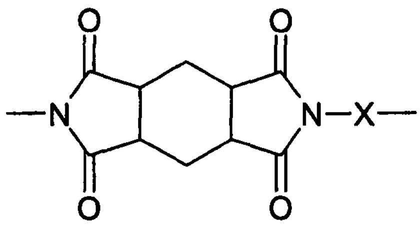

(1)

or a repeating unit represented by the formula (1) and a repeating unit represented by the following formula (2):

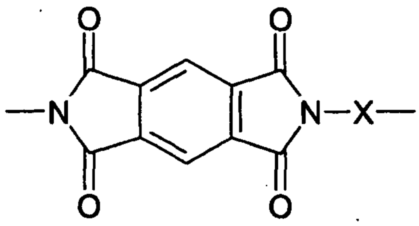

(2)

in the formulae (1) and (2), X represents a divalent aliphatic group having from 2 to 39 carbon atoms, a divalent alicyclic group having from 3 to 39 carbon atoms, a divalent aromatic group having from 6 to 39 carbon atoms or a divalent group composed of a combination thereof; at least one kind of a bonding group selected from the group consisting of -O-, $-SO_2-$, $-CH_2-$, $-C(CH_3)_2-$, $-OSi(CH_3)_2-$, -C2H40- and -S- may intervene in a main chain of X; and X may have at least one kind of a functional group selected from the group consisting of a carboxyl group, a hydroxyl group and a carbonyl group,
with a proportion of the total sum of at least one kind selected from a group presented by the following formula (3):

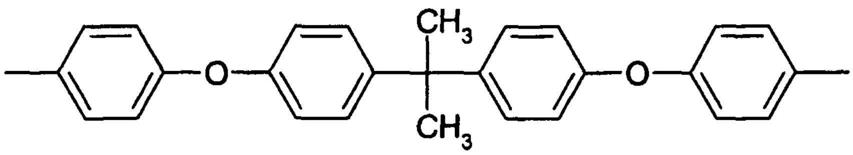

(3)

and a group represented by the following formula (4) :

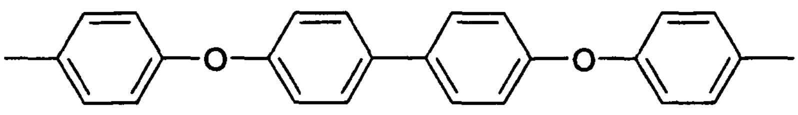

(4)

in the whole of X being 50 % by mole or more, and
a compound having two or more polymerizable double bonds in one molecule thereof which is a maleimide compound

and/or an epoxy (meth) acrylate compound.

2. The thermosetting polyimide resin composition according to claim 1, wherein a cured material thereof has a coefficient of water absorption of not more than 2.5 %.

3. A thermosetting polyimide resin composition solution containing the thermosetting polyimide resin composition according to claim 1 and an organic solvent.

4. An adhesive comprising the thermosetting polyimide resin composition according to claim 1.

5. A thermosetting polyimide resin composition film comprising the thermosetting polyimide resin composition according to claim 1.

6. A method for manufacturing a thermosetting polyimide resin composition film, which includes the steps of casting of the thermosetting polyimide resin composition solution according to claim 3 on a support and evaporating and removing the organic solvent.

7. The method for manufacturing a thermosetting polyimide resin composition film according to claim 6, wherein the organic solvent is evaporated and removed at a temperature of not higher than 120°C to form a self-supporting film; ends of the film having been peeled away from the support are fixed; and the film is dried at from 50 to 220°C.

8. A metal-clad laminate including an insulating base material, a metal layer and an adhesive layer disposed between the insulating base material and the metal layer, wherein the adhesive layer is formed of the thermosetting polyimide resin composition according to claim 1.

9. The metal-clad laminate according to claim 8, wherein the adhesive layer is formed by coating the thermosetting polyimide resin composition solution according to claim 3 on one or both of the insulating base material and the metal layer and subsequently evaporating and removing the organic solvent.

10. The metal-clad laminate according to claim 8, wherein the adhesive layer is formed of the thermosetting polyimide resin composition film obtained by the manufacturing method according to claim 6 or 7.

11. The metal-clad laminate according to any one of claims 8 to 10, wherein the surface of the metal layer opposing to the adhesive layer has a surface roughness Rz of from 0.1 to 4 μm.

12. The metal-clad laminate according to any one of claims 8 to 11, wherein the metal layer has a peel strength, as measured according to the peel strength measurement method of a copper foil by peeling at 90° in conformity with JIS C6471, of 0.5 N/mm or more.

**Patentansprüche**

1. Eine wärmehärtende Polyimidharzzusammensetzung, umfassend ein Polyimidharz, das eine sich wiederholende Einheit enthält, die durch die folgende Formel (1) dargestellt wird:

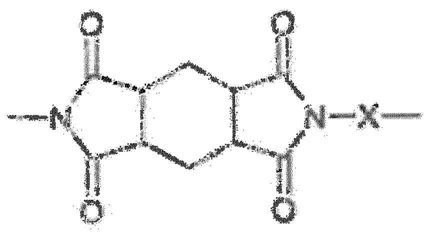

(1)

oder eine durch die Formel (1) dargestellte sich wiederholende Einheit und eine durch die Formel (2) dargestellte sich wiederholende Einheit:

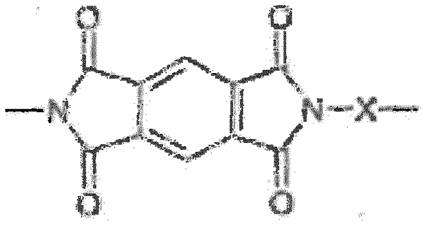

(2)

in den Formeln (1) und (2) stellt X eine divalente aliphatische Gruppe mit von 2 bis 39 Kohlenstoffatomen, eine divalente alicyclische Gruppe mit von 3 bis 39 Kohlenstoffatomen, eine divalente aromatische Gruppe mit von 6 bis 39 Kohlenstoffatomen oder eine aus Kombinationen daraus bestehende divalente Gruppe dar; mindestens eine Art einer Bindungsgruppe, ausgewählt aus der Gruppe, bestehend aus -O-, $-SO_2-$, $-CH_2-$, $-C(CH_3)_2-$, $-OSi(CH_3)_2-$, $-C_2H_4O-$ and -S-, kann in einer Hauptkette von X zwischengeschaltet sein; und X kann mindestens eine Art einer funktionellen Gruppe, ausgewählt aus der Gruppe, bestehend aus einer Carboxyl-Gruppe, einer Hydroxyl-Gruppe und einer Carbonyl-Gruppe enthalten,

mit einem Anteil an der Gesamtmenge mindestens einer Art, ausgewählt aus der durch die folgende Formel (3) dargestellten Gruppe:

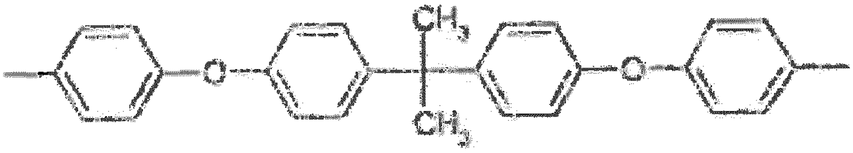

(3)

und einer durch die folgende Formel (4) dargestellten Gruppe:

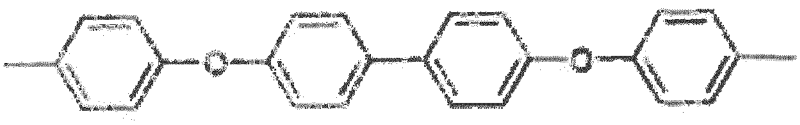

(4)

In der gesamten Menge von X von 50 Mol-% oder mehr, und

eine Verbindung mit zwei oder mehr polymerisierbaren Doppelbindungen in einem Molekül, die eine Maleimid-Verbindung und/oder eine Epoxy(meth)acrylat-Verbindung ist.

2. Die wärmehärtende Polyimidharzzusammensetzung nach Aspruch 1, wobei ein gehärtetes Material daraus einen Wasseraufnahmekoeffizlenten von nicht mehr als 2,5% hat.

3. Eine wärmehärtende Polyimidharzzusammensetzungs-Lösung, die die wärmehärtende Polyimidharzzusammensetzung nach Anspruch 1 und ein organisches Lösungsmittel enthält.

4. Ein Klebstoff, umfassend die wärmehärtende Polylmidharzzusammensetzung nach Anspruch 1,

5. Eine wärmehärtende Polyimidharzzusammensetzungs-Schicht, umfassend die wärmehärtende Polyimidharzzusammensetzung nach Anspruch 1.

6. Ein Verfahren zur Herstellung einer wärmehärtenden Polyimidharzzusammensetzungs-Schicht, umfassend die Schritte Gießen der wärmehärtenden Polyimidharzzusammensetzungs-Lösung nach Aspruch 3 auf einen Träger und Verdampfen und Entfernen des organischen Lösungsmittels,

7. Ein Verfahren zur Herstellung einer wärmehärtenden Polyimidharzzusammensetzungs-Schicht Anspruch 6, wobei das organische Lösungsmittel bei Temperaturen von nicht höher als 120°C verdampft und entfernt wird, um eine selbst-unterstützende Schicht zu bilden; die Enden der Schicht, die vom Träger abgezogen wurden, befestigt sind; und die Schicht bei 50 bis 220°C getrocknet wird.

8. Ein metall-plattiertes Laminat, enthaltend ein isolierendes Basismaterial, eine Metall-Schicht und eine Klebstoff-Schicht, die zwischen dem isolierenden Basismaterial und der Metallschicht angeordnet ist, wobei die Klebstoff-Schicht aus der wärmehärtenden Polyimidharzzusammensetzung nach Anspruch 1 gebildet wird,

9. Ein metall-plattiertes Laminat nach Anspruch 8, wobei die Klebstoff-Schicht durch Beschichten der wärmehärtenden Polyimidharzzusammensetzungs-Lösung nach anspruch 3 auf eine oder beide des isolierenden Basismaterials und der Metall-Schicht und sukzessives Verdampfen und Entfernen des organischen Lösungsmittels gebildet wird,

10. Ein metall-plattiertes Laminat nach Anspruch 8, wobei die Klebstoff-Schicht dus der wärmehärtenden Polyimidharzzusammensetzungs-Schicht gebildet wird, die nach dem Herstellungsverfahren nach Anspruch 6 oder 7 erhalten wird.

11. Ein metall-plattiertes Laminat nach einem der Ansprüche 8 bis 10, wobei die Oberfläche der Metall-Schicht, gegenüber der Klebstoff-Schicht, eine Oberflächenrauhigkeit $R_z$ von 0,1 bis 0,4 $\mu$m hat.

12. Ein metall-plattiertes Laminat nach der Ansprüche 8 bis 11, wobei die Metall-Schicht eine Schälfestigkeit von 0,5 N/mm oder mehr hat, gemessen entsprechend der Schälfestigkeits-Messmethode an einer Kupferfolie durch Schälen bei 90° in Übereinstimmung mit JIS C6471.

## Revendications

1. Composition de résine de polyimide thermodurcissable comprenant
une résine de polyimide contentant une unité récurrente représentée pal la formule (1) suivante :

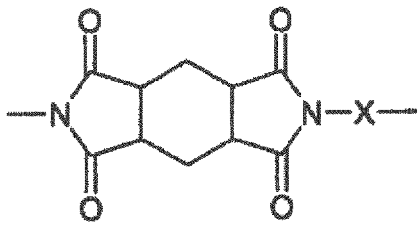

(1)

ou une unité récurrente représentée par la formule (1) et une unité récurrente représenté pal la formule (2) suivante :

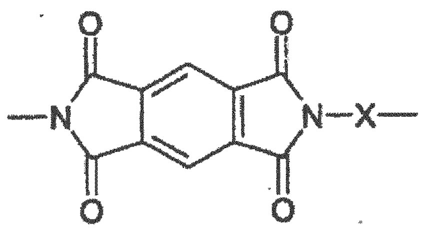

(2)

dans les formules (1) et (2) X représente un groupe divalent aliphatique ayant de 2 à 39 atomes de carbone, un groupe divalent allycyclique ayant de 3 à 39 atomes de carbone, un groupe divalent aromatique ayant de 6 à 39 atome de carbone ou un groupe divalent composé d'une combinaison de ceux-ci ; au moins une sorte d'un groupe liant sélectionné parmi le consistent en -O-, $-SO_2-$, $-CH_2-$, $-C(CH_3)_2-$, - $OSi(CH_3)_2-$, $-C_2H_4O-$ et -S- peut intervenir dans une chaîne principale de X ; et X peut avoir au moins une sorte d'un groupe fonctionnel sélectionné parmi le groupe consistant en un groupe carboxyle, un groupe hydroxyle et un groupe carbonyle.
avec une proportion du montant total d'au moins une sorte seléctionné parmi un groupe représenté par la formule (3) suivante :

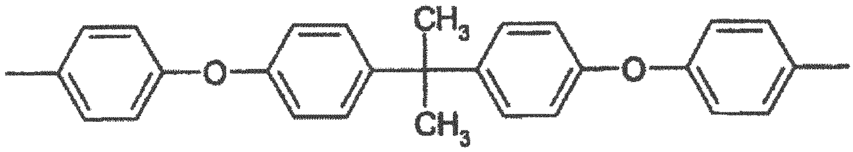

(3)

et un groupe représenté par la formule (4) suivante :

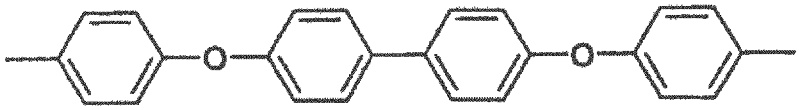

(4)

de l'ensemble de X étant égale ou supérieure à 50 % en mole est un composé ayant deux ou plus de deux doubles liaisons polymérisables dans un molécule de celui-ci, qui est un composé de maléimide et/ou un composé d'époxy (méth)acrylate.

**2.** Composition de résine de polyimide thermodurcissable selon la revendication 1, dans laquelle son matériau durci a un coefficient d'adsorption de l'eau de pas plus de 2,5 %.

**3.** Solution d'une composition de résine de polyimide thermodurcissable contenant la composition de résine de polyimide thermodurcissable selon la revendication 1 et un solvant organique.

**4.** Adhésive comprenant la composition de résine de polyimide thermodurcissable selon la revendication 1.

**5.** Film d'une composition de résine de polyimide thermodurcissable comprenant la composition de résine de polyimide thermodurcissable selon la revendication 1.

**6.** Procédé de production d'un film d'une composition de résine de polyimide thermodurcissable comprenant les étapes de couler la solution d'une composition de résine de polyimide thermodurcissable selon la revendication 3 sur un support et faire évaporer et éliminer le solvant organique.

**7.** Procédé de production d'un film d'une composition de résine de polyimide thermodurcissable selon la revendication 6, dans lequel le solvant organique est évaporé et éliminé à une température ne dépassant pas 1 20 °C pour former un film autoporteur ; les extrémités du film ayant été du support sont attachés ; et le film est séché à une température de 50 °C 220 °C.

**8.** Produit stratifié revêtu de métal comprenant un matériel de base isolant, une couche de métal et une couche adhésive disposée entre le matériel de base isolant et la couche de métal, dans lequel la couche adhésive est formée de la composition de résine de polyimide thermodurcissable selon la revendication 1.

**9.** Produit stratifié de métal selon la revendication 8, dans lequel la couche adhésive est par le de la solution d'une composition de résine de polyimide thermodurcissable selon la revendication 3 sur l'un ou les deux du matériel de base isolant et la couche de métal et ensuite faire évaporer et élimines le solvant organique.

**10.** Produit stratifié revêtu de métal selon la revendication 8, dans lequel la couche adhésive est formée du film d'une composition de résine de polyimide thermodurcissable obtenu par le procédé de production selon l'une des revendications 6 ou 7.

**11.** Produit stratifié revêtu de métal selon l'une des revendications 8 à 10, dans lequel la surface de la couche de métal opposée à la couche adhésive a une rugosité de surface Rz de 0,1 à 4 $\mu$m.

**12.** Produit stratifié de métal selon l'une des revendications 8 à 11, dans lequel la couche de métal a une résistante au pelage, tel que mesurée selon la méthode de mesure de la résistance au pelage d'une feuille de cuivre par pelage à 90° selon JIS C6471, égale ou supérieure à 0,5 N/mm.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1514888 A1
- JP 55091895 A
- JP 5032950 A
- JP 5059344 A
- JP 2001329246 A
- JP 2003168800 A
- US 3639343 A
- JP 2005001380 A
- JP 2005171106 A